# EUROPEAN PATENT SPECIFICATION

(11) **EP 1 801 151 B1**
(45) Date of publication and mention of the grant of the patent: **22.04.2009**
(21) Application number: 06077248.0
(22) Date of filing: 14.12.2006
(51) Int. Cl.: C08K 7/00, H01L 21/56, H01L 21/60

(54) **Methods of making a curable composition having low coefficient of thermal expansion and an integrated circuit and a curable composition and intergrated circuit made therefrom**
Verfahren zur Herstellung einer härtbaren Zusammensetzung mit niedrigem Wärmeausdehnungskoeffizienten, integrierte Schaltung, härtbare Zusammensetzung und damit hergestellte integrierte Schaltung
Procédé de fabrication d'une composition durcissable à faible coefficient d'expansion thermique et circuit intégré et composition durcissable et circuit intégré fabriqué à partir de celle-ci

(30) Priority: 23.12.2005 US 317661
(43) Date of publication of application: 27.06.2007
(73) Proprietor: Delphi Technologies, Inc., Troy, Michigan 48007 (US)
(72) Inventor: Basheer, Rafil A., Rochester Hills, MI 48309 (US); Bouguettaya, Mohammed, Sterling Heights, MI 48315 (US); Workman, Derek B., Noblesville, IN 46062 (US); Chaudhuri, Arun K., Carmel, IN 46032 (US)
(74) Representative: Denton, Michael John

(56) References cited:
- EP-A- 1 657 742
- EP-A- 1 700 875
- US-B1- 6 369 183
- US-B1- 6 376 100

## Description

### TECHNICAL FIELD

The invention relates to methods of making curable compositions that upon curing produce a three dimensional cross-linked matrix having a low coefficient of thermal expansion. More particularly, the invention relates to methods of making curable compositions useful in the production of integrated circuits, especially flip chip integrated circuits, methods of making such circuits, and compositions and circuits made there from.

### BACKGROUND OF THE INVENTION

Integrated circuits or integrated circuit assemblies are employed in a wide variety of electronic applications. Increasing demand for high performance yet reliable electronic products that are ever smaller, lighter, and cost effective have led to corresponding demands on the manufacturers of integrated circuits.

Such circuits have traditionally employed a circuit board and a die connected by a plurality of connectors, wires and/or solder bumps. It has been known that differences between the coefficients of thermal expansion (CTE) of the circuit board and die contribute to early fatigue failure of solder interconnects, especially during thermal cycling of the circuit assembly. Differences in CTE are especially problematic for integrated circuits used in environments subjected to high temperatures, such as applications in close proximity to internal combustion engines, i.e., on board motor vehicle applications.

Epoxy resins have been used in curable compositions useful in the manufacture of integrated circuits. In some cases, such curable resin compositions have functioned to anchor or adhere various components of the circuit and/or to mitigate the differences between the CTE's of the circuit components.

For example, epoxy resins have been utilized as underfill materials in the manufacture of integrated circuits having a flip-chip construction, i.e., 'flip chips'. Underfill materials are intended to support and protect the electrical connections of the flip chip while simultaneously reducing the thermo-mechanical stress on the flip chip connections. Epoxy resins have generally been found to provide advantageous adhesion between the various circuit components.

Unfortunately, many prior art epoxy resins have been unable to provide cured underfill materials having a desirably low CTE. Epoxy resins that provide a cured material having a CTE of 60 ppm/° C are especially advantageous in mitigating the differences between the CTEs of the die and circuit board. Thus, the prior art continues to seek epoxy resins that in and of themselves provide cured materials having low CTEs, especially cured materials having a CTE of 60 ppm/° C or less.

As a result, the prior art has often relied on the use of significant amounts of traditional CTE reducing fillers in order to obtain curable compositions that are useful in the manufacture of integrated circuits and that are based on epoxy resins.

Traditional CTE reducing fillers are characterized by average particle diameter sizes of no less than 1µm, and most often in the range of from 1 µm to 100 µm. Illustrative examples of such traditional CTE reducing fillers include carbon black, graphite, gold, silver, copper, platinum, palladium, nickel, aluminum, aluminum nitride, silicon carbide, boron nitride, diamond, alumina, vermiculite, mica, wollastonite, calcium carbonate, titania, sand, glass, silica, fused silica, fumed silica, barium sulfate, and halogenated ethylene polymers, such as tetrafluoroethylene, vinylidene fluoride, vinyl fluoride, vinylidene chloride, vinyl chloride, aluminum hydrates, magnesium hydrates, and combinations of such fillers when such fillers have an average particle diameter of from 1 µm to 100 µm..

Traditional CTE reducing fillers must generally be used in significant amounts in order to provide a cured underfill composition or material having a desirably low CTE such as 60 ppm/° C or less. As a result, traditional CTE reducing fillers are typically used in curable underfill compositions in amounts of from 20% to 85% by weight, or 20% to 50% by volume, respectively based on the total weight or total volume of the curable underfill composition, and more often in amounts of from 70 to 80 % by weight, based on the total weight of the curable underfill composition.

Unfortunately, the use of traditional CTE reducing fillers in such large amounts often results in increased manufacturing challenges and problems.

For example, circuit-manufacturing processes using capillary flow underfill technology typically require the injection of an epoxy resin based underfill composition into the interstitial spaces of an integrated circuit assembly. The presence of traditional CTE reducing fillers in such compositions can result in an increased viscosity that impedes the flow and distribution of the underfill composition. Such processes are also often characterized as unacceptably long and/or costly.

In no flow underfill processes the epoxy based underfill material is typically applied to the surface of an integrated circuit substrate. To join a die to the substrate, the die's flip chip bumps are pushed through the underfill material until the flip chip bumps make contact with corresponding substrate bumps. In this case, traditional CTE reducing filler particles can become undesirably trapped between the corresponding flip chip bumps and substrate bumps.

Attempts to incorporate nanoparticles compositions have been characterized by a reliance on the functionalization of the nanoparticles surface.

For example, U.S. Patent No. 6,369,183 teaches that handling and dispersing nanoparticles is difficult and requires the use of functionalized nanoparticles. It discloses methods and materials for covalently bonding chemically functionalized nanoparticle sized inorganic fillers comprising alumoxanes into a wide range of polymer matrices, including epoxy resins.

However, processes for producing functionalized nanoparticles are often expensive, complex and/or characterized by low yields and nonreproducible results.

Thus, there continues to be a need for curable compositions that provide cured materials having low CTEs that are useful in the design, manufacture and/or production of integrated circuits, especially flip chips. It would be especially advantageous to provide curable compositions useful in the production of integrated circuits that have a desirable balance of high modulus, low CTE and high T_{g}.

It would also be advantageous to provide a method of making such low CTE curable compositions that is independent of resin selection. That is, it would be advantageous to provide a method of lowering the CTE of any resin composition. In particular, there continues to be a need for fillers that reduce the CTE of curable compositions used in integrated circuits, especially epoxy based systems, but which do not cause the problems of traditional CTE reducing fillers.

### BRIEF DESCRIPTION OF THE DRAWINGS

Figure 1 is a cross-sectional view of one embodiment of the disclosed integrated circuit assembly.
Figure 2 is a cross-sectional view of an integrated circuit assembly made according to one embodiment of the disclosed method of making an integrated circuit assembly.
Figure 3 is a cross-sectional view of an integrated circuit assembly made according to a second embodiment of the disclosed method of making an integrated circuit assembly.

### SUMMARY OF THE INVENTION

Disclosed is a method of making a low CTE curable composition. The method comprises mixing together from 1 to 60.0 wt % of a nanoparticle composition (i) and from 20 to90 wt % of a curable binder (ii) to form a premixture. The method further comprises subjecting the premixture to high shear forces until the nanoparticle composition (i) is sufficiently dispersed in the curable binder (ii) to provide a curable composition, wherein the curable composition provides a cured composition having a coefficient of thermal expansion (CTE) of no more than 60 ppm/°C when cured for a time of from about 20 to about 60 minutes at temperature of from about 100 to 240°C. In order to provide a commercially feasible curable composition, it has unexpectedly been found that the nanoparticle composition (i) must be at least one of (a) a strongly functionalized nanoparticle composition functionalized with a carboxylic acid having at least one strongly functionalizing substituent group selected from the group consisting of a aromatic mono primary amine group, an aliphatic mono or di primary amine group, an aliphatic dihydroxyl of the formula (-CR(XOH)₂ wherein R is a C₁₋₅ alkyl group or H, X is CH₂ or an aromatic group, and n is 0 or 1), a phenol group, an alkoxy group, or mixtures thereof, and having less than or equal to 25 mole % functionalization, (b) a weakly functionalized nanoparticle composition functionalized with a mono hydroxyl substituted carboxylic or mono hydroxyl substituted sulfonic acid group and having from 1 to 100 mole % functionalization, (c) a nonfunctionalized nanoparticle composition, or (d) mixtures thereof.

Disclosed is a curable composition comprising (i) from 0.1 to 60.0 % by weight of a nanoparticle composition having an average particle size of less than 1000 nm when dispersed and which is at least one of (a) a strongly functionalized nanoparticle composition functionalized with a carboxylic acid having at least one strongly functionalizing substituent group selected from the group consisting of a aromatic mono primary amine group, an aliphatic mono or di primary amine group, an aliphatic dihydroxyl of the formula (-CR(XOH)₂ wherein R is a C₁₋₅ alkyl group or H, X is CH₂ or an aromatic group, and n is 0 or 1), a phenol group, an alkoxy group, or mixtures thereof, and having less than or equal to 25 mole % functionalization, (b) a weakly functionalized nanoparticle composition functionalized with a mono hydroxyl substituted carboxylic or mono hydroxyl substituted sulfonic acid group and having from 1 to 100 mole % functionalization, (c) a nonfunctionalized nanoparticle composition, or (d) mixtures thereof, and (ii) from 20.0 to 90.0 % by weight of a curable binder, based on the total weight of the curable composition, wherein the curable composition is characterized by (1.) a coefficient of thermal expansion (CTE) of no more than 60 ppm/°C when cured for a time of from about 20 to about 60 minutes at temperature of from about 100 to 240°C, (2.) a modulus of elasticity of no less than 5.0 Gpa when cured for a time of from about 20 to about 60 minutes at temperature of from about 100 to 240°C, and (3) a glass transition temperature of no less than 80°C.

Also provided is a method of making a low CTE cured composition, the method comprising applying the curable composition resulting from the disclosed method to a substrate to provide a coated substrate, and curing the coated substrate to provide a cured composition having a coefficient of thermal expansion (CTE) of no more than 60 ppm/°C.

A method of making an integrated circuit assembly is disclosed, comprising applying the curable composition made by the disclosed method to a substrate, placing a die in communication with the applied composition, and curing the applied composition to provide an integrated circuit assembly, wherein at least one of the substrate or die comprises one or more bumps.

Finally, also disclosed is another method of making an integrated circuit comprising providing a substrate comprising one or more substrate bumps thereon, applying the curable composition made by the disclosed method to the substrate, placing a die on the applied curable composition, said die comprising one or more flip chip bumps, subjecting the assembly to a temperature sufficient to cause flow and joining of the bumps, and subjecting the assembly to a temperature sufficient to cause curing of the applied curable composition.

### DESCRIPTION OF THE PREFERRED EMBODIMENTS

The singular forms "a", "an" and "the" include plural referents unless the context clearly dictates otherwise.

"Optional" or "optionally" means that the subsequently described event or circumstance may or may not occur, and that the description includes instances where the event occurs and instances where it does not.

The modifier "about" used in connection with a quantity is inclusive of the stated value and has the meaning dictated by the context (e.g., includes the degree of error associated with measurement of the particular quantity).

'Curable' as used herein refers to thermoset compositions that can, when subjected to appropriate energy, cure to form a three-dimensional cross linked matrix. In one embodiment, the curable compositions will crosslink upon the application of sufficient thermal energy.

A "low CTE curable composition" refers to a curable composition that upon curing provides a three dimensional crosslinked matrix that has a CTE of no more than 60 ppm/°C.

It will be appreciated that the obtainment of low CTEs has been particularly difficult to obtain with regards to epoxy-based compositions useful as underfill materials in integrated circuits. More particularly, those of skill in the art will appreciate that numerous competing factors affect the obtainment of curable compositions that result in cured compositions having a low CTE. Such factors include but are not limited to cross link density, rigidity, molecular packing, steric hindrance, and reaction kinetics. Those of skill in the art have been unable to conclusively identify which factor will weight most heavily in any particular composition. Thus, it will be appreciated that it has been difficult to reliably formulate epoxy-based compositions that cure to provide underfill materials having a low CTE for a given curing profile.

Disclosed are methods for making low CTE curable compositions and the compositions resulting there from as well as integrated circuits made with the disclosed compositions.

In one embodiment, the disclosed method comprises mixing together (i) from 0.1 to 60.0 % by weight of a nanoparticle composition having an average particle size of less than 1000 nm and (ii) from 20.0 to 90.0 % by weight of a curable binder to provide a premixture, based on the total weight of the premixture, and subjecting the premixture to high shear forces until the nanoparticle composition (i) is sufficiently dispersed in the curable binder (ii) to provide a curable composition. In order to provide a commercially feasible curable composition, it has unexpectedly been found that the nanoparticle composition (i) must be at least one of (a) a strongly functionalized nanoparticle composition functionalized with a carboxylic acid having at least one strongly functionalizing substituent group selected from the group consisting of a aromatic mono primary amine group, an aliphatic mono or di primary amine group, an aliphatic dihydroxyl of the formula (-CR(XOH)₂ wherein R is a C₁₋₅ alkyl group or H, X is CH₂ or an aromatic group, and n is 0 or 1), a phenol group, an alkoxy group, or mixtures thereof, and having less than or equal to 25 mole % functionalization, (b) a weakly functionalized nanoparticle composition functionalized with a mono hydroxyl substituted carboxylic or mono hydroxyl substituted sulfonic acid group and having from 1 to 100 mole % functionalization, (c) a nonfunctionalized nanoparticle composition, or (d) mixtures thereof.

It is an aspect of the disclosed method that the resulting curable composition provides a cured composition having a coefficient of thermal expansion (CTE) of no more than 60 ppm/°C when cured for a time of from about 20 to about 60 minutes at temperature of from about 100 to 240°C.

The term 'nanoparticle composition' as used herein refers to inorganic filler particles designed to or capable of having an average particle diameter of less than 1000 nm when dispersed. It will be appreciated that average particle diameter may be substantially larger in their virgin or undispersed state. In one embodiment, nanoparticle compositions will have an average particle diameter of less than 500 nm when dispersed. In one exemplary embodiment, the nanoparticle composition (i) will have an average diameter of from 1 to 100 mn when dispersed.

Illustrative examples of suitable nanoparticle compositions (i) for use in the premixture of the disclosed method include inorganic nanoparticle fillers of aluminum oxide hydroxide, magnesium oxide, hydroxyapatite, and the like.

Aluminum oxide hydroxide is to be broadly construed to include any material whose surface is or can be processed to form a shell or layer of boehmite, including specifically aluminum metal, aluminum nitride, aluminum oxynitride (AION), α-Al₂O₃, γ-Al₂O₃, transitional aluminas of general formula Al₂O₃, boehmite (γ-AlO(OH)), pseudoboehmite (γ-AlO(OH)·x H₂O where 0<x<1), diaspore (α-AlO(OH)), and the aluminum hydroxides (Al(OH)₃) of bayerite and gibbsite. Thus, aluminum oxyhydroxide particles in this invention are any finely divided materials with particle sizes less than 1 mm and a surface shell comprising at least 5% of aluminum oxyhydroxide. Boehmite and pseudoboehmite are aluminum oxyhydroxides of the general formula γ-AlO(OH)·xH₂O. When x=0 the material is called boehmite; when x>0 and the materials incorporate water into their crystalline structure they are known as pseudoboehmite. Boehmite and pseudoboehmite are also described as Al₂O₃·zH₂O where, when z=1 the material is boehmite and when 1<z<2 the material is pseudoboehmite. The above materials are differentiated from the aluminum hydroxides (e.g. Al(OH)₃, bayerite and gibbsite) and diaspore (α-AlOOH) by their compositions and crystal structures. Boehmite is usually well crystallized with a structure in accordance with the x-ray diffraction pattern given in the JCPDS-ICDD powder diffraction file 21-1307, whereas pseudoboehmite is less well crystallized and generally presents an XRD pattern with broadened peaks with lower intensities. For the purposes of this specification, the term 'boehmite' implies boehmite and/or pseudoboehmite. Thus, boehmite particles in this invention are any finely divided materials with a particle size less then 5 mm and a surface shell comprising at least 5% of boehmite and/or pseudoboehmite.

In one exemplary embodiment, the aluminum oxide hydroxide will be boehmite or pseudoboehmite, hereafter 'boehmite. Boehmite can be commercially obtained. Illustrative examples include commercially available boehmite products such as Catapal (A, B, C, D, or FI) from Sasol North America Inc., boehmite prepared by the precipitation of aluminum nitrate with ammonium hydroxide and then hydrothermally treated at 200°C. for 24 hours, or boehmite prepared by the hydrolysis of aluminum trialkoxides followed by hydrothermal treatment at 200°C. Preferred methods for the preparation of the pseudoboehmite or boehmite particles are those that produce particle sizes of the carboxylate-alumoxanes below 1000 nm, more preferably below 100 nm.

Suitable magnesium oxide nanoparticle fillers are commercially available from Nanoscale Materials Inc., as MgO plus.

Suitable hydroxyapatite, i.e., [3Ca₃(PO₄)₂•Ca(OH)₂] is commercially available from Aldrich Chemical Company as #289396 hydroxyapatite powder.

In one exemplary embodiment, the nanoparticle composition (i) will be comprised of boehmite.

In one embodiment, the above illustrative examples of suitable nanoparticle compositions (i) may be used in their 'pristine' or untreated state. Alternatively, in another embodiment, the suitable nanoparticle compositions (i) will be as described above but will have a surface modified by reaction with an organic surface treatment agent such as a carboxylic acid or sulfonic acid. Such surface modified nanoparticle compositions are known as 'functionalized' nanoparticle compositions.

Illustrative examples of functionalized nanoparticle compositions (i) include carboxylate-alumoxanes and/or sulfonate-alumoxanes.

Carboxylate-alumoxanes are inorganic-organic hybrid materials that contain a boehmite-like ([AlO(OH)]n) aluminum oxygen core, to whose surfaces are attached covalently bound carboxylate groups (i.e., RCO2-, where R=alkyl or aryl group) (Landry et al., 1995). The carboxylate groups are tethered to the aluminum-oxygen surface through bidentate bonding of the carboxylate group to two aluminum atoms on the surface of the boehmite particle. The properties and processability of the carboxylate-alumoxanes are strongly dependent on the nature and size of the attached functionalizing groups. Similarly, sulfonate-alumoxanes have an aluminum oxygen core covalently bonded to sulfate groups (i.e., RSO₂-, R=alkyl or aryl).

In one embodiment, carboxylate-alumoxanes or sulfonate-alumoxanes may be prepared by the reaction of boehmite or pseudoboehmite with carboxylic or sulfonic acids in a suitable solvent. The carboxylic or sulfonic acid can be any monocarboxylic acid. The acids can be aromatic or aliphatic, and can contain hetero-atom functional groups such as hydroxyls, amines, etc. In one embodiment, suitable acids will contain at least one terminal amine or hydroxyl.

Illustrative examples of suitable acids include 4-hydroxybenzoic acid, 4-aminobenzoic acid, dimethylolpropionic acid, diphenolic acid, 6-aminohexanoic acid, lysine, 4-aminobenzene sulfonic acid, diamino benzene sulfonic acid, glycolic acid, and the like. In one embodiment, if functionalized nanoparticles are employed as the nanoparticle composition (i), the functionalizing acid will be one of 4-aminobenzoic acid, 4-aminobenzene sulfonic acid, diaminobenzoic acid, diamino benzene sulfonic acid, or glycolic acid.

The reaction of the pseudoboehmite (or boehmite) with the functionalizing acid can be carried out in either water or a variety of organic solvents (including, but not limited to toluene and xylene). However, it is preferable to use water as the solvent so as to minimize the production of environmentally problematic waste. In a typical reaction, the carboxylic acids are added to boehmite or pseudoboehmite particles, the mixture is heated to reflux, and then stirred for a period of time. The water is removed and the resulting solids are collected. The solids can be re-dispersed in water or other solvents in which the alumoxane and other polymer precursor components are soluble.

The prior art, such as U.S. Patent 6,369,183 to Cook et al., has taught that commercially feasible handling, use, and/or dispersion of inorganic nanoparticle fillers is possible only with highly functionalized nanoparticles, most of which appear to be functionalized to the maximum degree, i.e., 1:0:0.5 alumoxane:carboxylic acid mole ratio. In particular, it appears that the prior art deems the interaction of the amine or hydroxyl group of the carboxylic acid with the polymer as necessary to dispersion and the production of a functionalized alumoxane/polymer mixture or composite.

However, it has unexpectedly been found that if functionalized nanoparticles are employed, only a certain type of limited or weakly functionalized nanoparticle composition should be utilized for the production of low CTE curable compositions, especially those also having a high modulus and high T_{g}. As illustrated below in the comparative examples, certain 'strongly functionalized' nanoparticles appear to result in curable compositions that have unacceptable performance properties, especially with regards to processability.

The term 'strongly functionalized' nanoparticle as used herein refers to a nanoparticle composition having a high mole % functionalization of certain functionalizing acids having at least one strongly functionalizing substituent group selected from the group consisting of an aromatic mono primary amine group, an aliphatic mono or di primary amine group, an aliphatic dihydroxyl of the formula (-CR(XOH)₂ wherein R is a C₁₋₅ alkyl group or H, X is CH₂ or an aromatic group, and n is 0 or 1), a phenol group, an alkoxy group, or mixtures thereof.

It has been found in one embodiment, that when a strongly functionalized nanoparticle (a) is employed as nanoparticle composition (i) in the disclosed method, the strongly functionalized nanoparticle composition (a) must have a mole % functionalization that is less than or equal to 25 mole % functionalization. In another embodiment, a strongly functionalized nanoparticle (a) employed as nanoparticle composition (i) will have a mole % functionalization that is less than or equal to 10 mole % functionalization. In one exemplary embodiment, a strongly functionalized nanoparticle composition (a) employed as nanoparticle composition (i) will have a mole % functionalization that is between 5 and 9 mole % functionalization.

Alternatively, it has been found that certain other functionalized nanoparticles having higher mole % functionalization may be employed in the disclosed method if acids having weakly functionalizing substituent groups are employed as the functionalizing acid.

For example, it has been found that mono aliphatic hydroxyl substituted carboxylic or mono aliphatic hydroxyl substituted sulfonic acids are weakly functionalizing acids that may be used to produce weakly functionalizing nanoparticle compositions (b). Such weakly functionalizing nanoparticle compositions (b) may be used as nanoparticle compostion (i) in the disclosed method at mole % functionalizations of from 1 to 50 mole % functionalization. It will be appreciated that 50 mole% functionalization is the maximum functionalization possible. In another embodiment, a weakly functionalized nanoparticle (b) employed as nanoparticle composition (i) may have a mole % functionalization of from 10 to 50 mole % functionalization. In one exemplary embodiment, a weakly functionalized nanoparticle composition (b) employed as nanoparticle composition (i) in the disclosed method will have a mole % functionalization that is between 20 and 50 mole % functionalization.

It has also been found that nonfunctionalized nanoparticles (c) may be employed to advantage as nanoparticle composition (i). As indicated below in the comparative results, the disclosed method facilitates the use of less costly nonfunctionalized nanoparticles as compared to functionalized nanoparticles.

Finally, it has also been found that mixtures (d) of two or more of strongly functionalized nanoparticles (a), weakly functionalized nanoparticles (b) and nonfunctionalized nanoparticles (c) may be employed as nanoparticle composition (i) in the disclosed method.

In one embodiment, the nanoparticle composition (i) will comprise at least 51% by weight of nonfunctionalized nanoparticle composition (c), based on the total weight of nanoparticle composition (i). In one exemplary embodiment, the nanoparticle composition (i) will comprise at least 75% by weight of nonfunctionalized nanoparticle composition (c). In an especially exemplary embodiment, the nanoparticle composition (i) will consist of nonfunctionalized nanoparticle composition (c), i.e., 100 % by weight of nonfunctionalized nanoparticle composition (c), based on the total weight of nanoparticle composition (i).

Accordingly, in one exemplary embodiment, the disclosed methods and resulting compositions will employ weakly or nonfunctionalized inorganic fillers (b) and (c) as the nanoparticle composition (i). In one particularly exemplary embodiment, the disclosed methods and resulting compositions will employ weakly or nonfunctionalized boehmite or magnesium oxide as the nanoparticle composition (i). In one especially exemplary embodiment, the disclosed methods and resulting compositions will employ nonfunctionalized boehmite as the nanoparticle composition (i).

The premixture will further comprise a curable binder (ii). The curable binder (ii) may be a curable resin (iia), a curing or crosslinking agent (iib) or a combination thereof. Illustrative examples of suitable curable resins (iia) include epoxy resins (e.g., bisphenol A resins, bisphenol F resins, cycloaliphatic epoxy resins, and mixtures thereof), cyanate esters, siloxiranes, maleimides, polybenzoxazines, polyimides, novolac based epoxy resins, cresol based epoxy resins, triglycidyl of para, amino phenol epoxy resins tetraglycidyl of diaminodiphenyl methane and the like, as well as mixtures thereof.

In one exemplary embodiment, the curable resin (iia) will be an epoxy resin. In one especially exemplary embodiment, the curable resin (iia) will be a particular epoxy compound of the structure:

X-((CH₂)ₘ-(N)-((CH₂)ₙ-(Z))₂)ₚ

wherein X comprises an aromatic ring or a six membered cycloaliphatic ring containing structure, m is from about 0 to about 2, n is from about 1 to about 3, Z is an epoxy group of the empirical formula: C₂H₃O, and p is a number from about 2 to about 3. In one embodiment, X will be an aromatic ring or a six membered cycloaliphatic ring. In another embodiment, X will be an aromatic ring, while m is from 0 to about 1, and n is from about 1 to 2. In one exemplary embodiment, m is 1, n is 1, and p is 2.

In one embodiment, when p is 2, the substituent groups "-(CH₂)ₘ-(N)-((CH₂)ₙ-(Z))" will be arranged to provide a structure wherein the substituent groups are located in the 1, 3; 1, 2; or 1, 4 positions of the aromatic or cycloaliphatic ring in regards to an axis through the X group. In one exemplary embodiment, the substituent groups "-(CH₂)ₘ-(N)-((CH₂)ₙ-(Z))" of the at least one epoxy compound will be arranged in a meta structure, i.e., the 1, 3 structure.

Particularly suitable examples of this particular epoxy resin include N,N,N',N'-tetraglycidyl-*meta*-xylenediamine and 1,3-bis(N,N-diglycidylaminomethy)cyclohexamine. Such resins are commercially available from Mistsubishi Gas Chemical Company of Tokyo, Japan as Tetrad™-C and Tetrad™-X or ERISYS™ GA-24O from CVC Speciality Chemicals of Morristown, New Jersey. In one exemplary embodiment, the curable binder (ii) will be N,N,N',N'-tetraglycidyl-*meta*-xylenediamine.

In one embodiment, the curable binder (ii) will comprise at least 50% by weight of the above particular epoxy compound discussed above, based on the total nonvolatile weight of the curable binder (ii). In one embodiment, the curable binder (ii) will comprise no less than 95% by weight of the at least one epoxy compound, while in one exemplary embodiment, the curable binder (ii) will comprise from 80 to 100% by weight of the particular epoxy, based on the total nonvolatile weight of the curable binder (ii). In one exemplary embodiment, the curable binder (ii) will comprise from 98 to 100% by weight of the above particular epoxy, based on the total nonvolatile weight of the curable binder (ii). In another exemplary embodiment, the binder (i) will comprise 100% by weight of the particular epoxy, based on the total nonvolatile weight of the binder (i). Thus, in one exemplary embodiment, curable binder (ii) will consist solely of the above particular epoxy resin having the above identified structure.

The disclosed methods and resulting curable compositions may also comprise a crosslinking agent or curing agent (iib). In one embodiment, the crosslinking agent (iib) will be a separate compound added to either the premixture or the curable composition. In one embodiment, the crosslinking or curing agent (iib) will be added to the premixture before it is subjected to high shear dispersion techniques. In another embodiment, the crosslinking or curing agent (iv) will be added to the premixture either during or after dispersion of the nanoparticle composition (i) into the curable binder (ii).

In one embodiment, the curing agent (iib) may be a strongly functionalized nanoparticle composition (a) or a weakly functionalized nanoparticle composition (b) as described above. In one embodiment, the curing agent (iv) will be a strongly functionalized nanoparticle composition (a) wherein a nanoparticle composition has been modified with either less than 25 mole % of a strongly functional amine or hydroxyl functional carboxylic or sulfonic acid or 20-50% mole % function of a monohydroxyl carboxylic or sulfonic acid.

In another embodiment, the curing agent (iib) may be combination of a functionalized nanoparticle composition (i), and a polyamine curing agent as described below.

In another embodiment, the curing agent (iib) will comprise a curing agent such as a polyamine or an imidazole.

Suitable imidazoles are those that have a high reaction temperature, i.e., over 100 degrees C, preferably over 150 degrees C. Illustrative examples include 2-phenylimidazole, 2-phenyl-4-methylimidazole (known as 2P4MZ), and the like.

In one embodiment, it has been found that a curable composition comprising a nanoparticle composition (i), curable resin (iia) and a crosslinking agent (iib) comprising at least one particular polyamine provides a cured composition having a low CTE. That is, in one embodiment, the selection of a particular polymine as a crosslinking agent (iib) is believed to contribute to the obtainment of a curable composition that after curing has a low CTE at a particular curing profile, a high modulus of elasticity and a high T_{g}.

In one embodiment, suitable amines may be those polyamines having a structure that contributes to increased cross link density, increased rigidity, and increased molecular packing but which do not possess undesirable degrees of steric hindrance and/or which do not contribute to undesirable reaction kinetics. In this case, suitable polyamines are those having from 2 to 4 primary amine groups, but especially 2 primary amine groups.

Suitable polyamines may also comprise one or more heteroatoms. Illustrative heteroatoms and groups comprising heteroatoms include halogen atoms, O, S, hydroxyl groups, secondary amine groups, ester groups, alkoxy groups, ester groups, ether groups, thiol groups, carbonate groups (-CO₂), sulfonate groups (-SO₂), mixtures thereof, and the like. In one especially exemplary embodiment, the at least one polyamine will comprise heteroatoms, especially O.

In one embodiment, crosslinking agent (iib) will comprise at least one polyamine having a structure comprising at least one aromatic ring and from 2 to 4 primary amine groups, but especially 2 primary amine groups. In one exemplary embodiment, the at least one polyamine will have a structure having a molecule having more than 1 aromatic ring, especially more than 2 aromatic rings. In one especially exemplary embodiment, the at least one polyamine will have a structure having a molecule having 3 aromatic rings. In yet another embodiment, the at least one polyamine will have the structure:

(R)ₚ-(NH₂)_{q}

wherein R is at least one of an aromatic ring or a cycloaliphatic ring, (R₁-W)ₖ-R₂, (R₁-W-R₂)ₖ, and combinations thereof, p is from about 1 to about 4, and q is from about 2 to about 4. When R comprises an aromatic ring or cycloaliphatic ring, they may be either substituted or unsubstituted and may or may not comprise heteroatoms or groups comprising heteroatoms as discussed immediately above. Suitable R groups may thus be at least one of a substituted or unsubstituted aromatic ring, a substituted or unsubstituted six membered cycloaliphatic ring, a substituted or unsubstituted heteroaromatic ring, a substituted or unsubstituted six membered cycloheteroaliphatic ring, and combinations thereof. With regard to combinations of such structures, suitable R groups may comprise more than one of each type of structure, i.e., two or more aromatic rings in combination with one or more of the other identified structures.

If substituted, the aromatic ring or cycloaliphatic ring suitable for use in R may comprise one or more substituent groups such as alkyl groups, alkoxy groups, heteroatoms, groups comprising heteroatoms, and mixtures thereof. Suitable alkyl groups and alkoxy groups will generally be those having less than 5 carbon atoms, especially those having from 1 to 3 carbon atoms.

In one exemplary embodiment, R will comprise unsubstituted aromatic rings, especially more than one unsubstituted aromatic ring. In one especially exemplary embodiment, R will comprise three unsubstituted aromatic rings.

In the above structures, R₁ and R₂ may be the same or different and are defined as R is above, W is at least one of an alkyl group of from 1 to 3 carbons, a heteroatom, a heteroatom containing radical, and combinations thereof, and k is from about 1 to about 4.

In another embodiment, the at least one polyamine will have the structure:

(R)ₚ-(NH₂)_{q}

wherein R comprises at least one structure selected from a substituted aromatic ring, an unsubstituted aromatic ring, a substituted heteroaromatic ring, an unsubstituted heteroaromatic ring, and mixtures thereof, p is from about 1 to about 4, and q is from about 2 to about 4, with all terms having the definitions as discussed above.

In one exemplary embodiment, the crosslinking agent (iib) will comprise a polyamine of the structure:

((R₁-W)ₖ-R₂)ₚ-(NH₂)_{q}

wherein R₁ and R₂ may be the same or different and are at least one of a substituted aromatic ring, an unsubstituted aromatic ring, a substituted heteroaromatic ring, or an unsubstituted heteroaromatic ring, and combinations thereof, W is at least one of O, S, SO₂, -CO₂, or combinations thereof, p is from about 1 to about 2, and q is from 2 to about 3.

In one exemplary embodiment, the at least one polyamine will be at least one of 1,3-bis(3-aminophenoxy)benzene, 1,3-bis(4-aminophenoxy)benzene, 1,4-bis(4-aminophenoxy)benzene, 4,4'-diaminodiphenyl sulfide, 2,4-diaminotoluene, 3,4-diaminotoluene, 2,3-diaminotoluene 1,3 phenylenediamine, diaminobenzidine, 1,3-benzenediamine, 4,4'-diaminodiphenyl methane, 1-[(3-aminophenyl)amino]-3-phenoxy, 1-[[4-[(4-aminophenyl)methyl]phenyl]amino]-3-phenoxy, polymeric methylene dianiline, and combinations comprising two or more of the foregoing. In one especially exemplary embodiment, the at least one polyamine will be at least one of 1,3-bis(3-aminophenoxy)benzene, 1,3-bis(4-aminophenoxy)benzene, or 1,4-bis(4-aminophenoxy)benzene.

In one embodiment, the crosslinking agent (iib) may comprise amines and polyamines other than the at least one polyamine discussed above. In one embodiment, the crosslinking agent (iib) will comprise at least 50% by weight of the at least one polyamine discussed above, based on the total nonvolatile weight of the crosslinking agent. In one embodiment, the crosslinking agent (iib) may comprise no less than 95% by weight of the at least one polyamine, while in one exemplary embodiment, the crosslinking agent (iib) will comprise from 80 to 100% by weight of the at least one polyamine, based on the total nonvolatile weight of the crosslinking agent. In one exemplary embodiment, the crosslinking agent (iib) will comprise from 98 to 100% by weight of the particular polyamine, based on the total nonvolatile weight of the crosslinking agent (iib). In another exemplary embodiment, the crosslinking agent (iib) will comprise 100% by weight of the particular polyamine, based on the total nonvolatile weight of the crosslinking agent (iib). Thus, in one exemplary embodiment, crosslinking agent (iib) will consist solely of the at least one polyamine discussed above.

In one exemplary embodiment, the at least one polyamine will be used in a stoichometric or near stoichometric amount relative to the above particular one epoxy.

The disclosed curable composition may also comprise a catalyst (v). Optional catalyst (v) may be present in an amount of from 0 to 5.0% by weight, based on the total weight of the curable composition. In another embodiment, the catalyst (v) will be present in an amount of from 0.1 to 5.0 % by weight, based on the total weight of the curable composition. In one exemplary embodiment, the catalyst (v) will be present in an amount of from 0.2 to 2.0% by weight, based on the total weight of the curable composition. In one especially exemplary embodiment, the catalyst (v) will be present in an amount of from 0.5 to 1.0% by weight, based on the total weight of the curable composition.

Suitable optional catalysts (v) are those that affect the desired behavior of the formulation. For instance, catalysts (v) may be used to promote cross-linking and/or to control the curing time of the resin. In one embodiment, the catalyst (v) will be a Lewis acid. Suitable examples of catalysts (v) include salts of trifluoromethane sulfonic acid, BF₃/amine complexes, imidazoles, phosphines, dicyanamide, and substituted dicyamide compounds. In one embodiment, the catalyst (v) will be at least one of a salt of trifluoromethane sulfonic acid or a BF₃/amine complex. In one exemplary embodiment, the catalyst (v) will be a salt of trifluoromethane sulfonic acid.

Examples of suitable salts of trifluoromethane sulfonic acid include, but are not limited, to lithium triflate, amine triflate, and the lanthanide metal series of triflates. A commercially available example of a suitable salt of trifluoromethane sulfonic acid is FC520, a 60% solution of diethylamine triflate, commercially available from 3M of St. Paul, Minnesota.

In one exemplary embodiment, the catalyst (v) will comprise at least one of (CF₃-SO₃)ₙMⁿ⁺, (CF₃-SO₃)NR³R⁴, (BF₃)NR³R⁴ or mixtures thereof, wherein n is from about 1 to about 2, M is a metal, R³ and R⁴ may be the same or different and are at least one of H, an alkyl group and mixtures thereof. Suitable alkyl groups include those having from 1 to 20 carbon atoms, with 1 to 6 carbon atoms being particularly suitable. R₃ and R₄ may also be a fused or cylco alphitic or aromatic ring, that may contain heteratome. M may be any metal, including but not limited to alkali metals, alkali earth metals, transition metals, lanthanide metals, and the like. In one exemplary embodiment, M will be at least one metal selected from Li, Ce, La, Nd, Eu, Yb, and combinations thereof.

In one exemplary embodiment, the catalyst (v) will be FC520.

In one embodiment, the triflate salts may be added to the curable composition via solution with a polyol such as glycerol. Alternatively, the triflate salt may be added directly (no glycerol) to the premixture or to curable composition as long as care is taken to insure uniform distribution of the salt in the curable composition.

The disclosed curable composition may optionally comprise one or more optional components such as solvents, additives, accelerators, fluxing agents, coupling agents, toughening agents, diluents, impact modifiers, aliphatic amines, stabilizers, antioxidants, antifoaming agents, adhesion agents, elastomers, flame retardants, and combinations comprising two or more of the foregoing. Such optional components may be used in amounts of from about 0 to 80% by weight, per optional component, based on the total weight of the disclosed curable composition.

Coupling agents may be used in order to improve the adhesion property of the underfill. Examples of suitable coupling agents include silanes, titanates, zirconates, aluminates, silicate esters, metal acrylates or methacrylates, compounds containing a chelating ligand (e.g., phosphine, mercaptan, acetoacetate), and/or mixtures thereof. The kinds and amounts of coupling agents that may be used are known to those skilled in the art. Illustrative amounts of coupling agents are 0 to 5 % weight based on total curable composition.

Suitable fluxing agents may be acidic, basic, or neutral. Examples of acidic fluxing agents include organic acids such as acrylic acid, heptanoic acid, lauric acid, palmitic acid, and valeric acid. Examples of neutral fluxing agents include alcohols or polyols. Fluxing agents may be used in amounts of from 0 to 20% by weight, based on total curable composition.

Examples of impact modifiers include thermoset and thermoplastic materials having a T_{g} of 50°C or less, including core-shell rubber particles. Suitable compounds include polyacrylates, polymerized THF (tetrahydrofuran), carboxy-terminated butyronitrile rubber, and polypropylene glycol. When present, these compounds may be in an amount of from about 10 to about 20 weight percent of the total curable composition.

Suitable flame retardants may include halogenated materials, organic phosphates, and combinations thereof, and may be used in amounts of from 0 to 25% by weight based on total curable composition

Suitable additional accelerators include imidazoles and the reaction products of diglycidyl ether of bisphenol A with polyamines or with imidazoles.

The disclosed method of making the disclosed curable compositions requires the preparation of a premixture comprising nanoparticle composition (i) and curable binder (ii).

In one embodiment, the premixture will comprise from 0.1 to 60.0 weight % of the nanoparticle composition (i), based on the total weight of the curable composition. In another embodiment, the premixture will comprise from 1.0 to 50.0 weight % of the nanoparticle composition (i), based on the total weight of the curable composition. In yet another embodiment, the premixture will comprise from 10.0 to 45.0 weight % of the nanoparticle composition (i), based on the total weight of the curable composition. In one exemplary embodiment, the premixture will comprise from 20.0 to 40.0 weight % of the nanoparticle composition (i), based on the total weight of the curable composition.

Similarly, in one embodiment, the premixture will comprise from 20.0 to 90.0 weight % of the curable binder (ii), based on the total weight of the curable composition. In another embodiment, the premixture will comprise from 30.0 to 80.0 weight % of the curable binder (ii), based on the total weight of the curable composition. In yet another embodiment, the premixture will comprise from 50.0 to 75.0 weight % of the curable binder (ii), based on the total weight of the curable composition. In one exemplary embodiment, the premixture will comprise from 65.0 to 75.0 weight % of the curable binder (ii), based on the total weight of the curable composition.

Optionally, in one embodiment, the premixture may further comprise an organic liquid (iii) that may or may not be a solvent for the curable binder (ii). In one embodiment, the organic liquid will be any viscosity lowering liquid. That is, in one embodiment, the premixture may be a suspension.

Illustrative examples of suitable organic liquids (iii) include polar and nonpolar organic liquids, and combinations thereof. Illustrative examples of suitable optional organic liquids (iii) include water, alcohols such as methanol, ethanol and the like, ketones such as acetone and methylethyl ketone, tetrahydrofuran, halogenated liquids such as chloroform, acetates such as butyl acetate, aromatic solvents such as xylene, toluene and the like, as well as mixtures thereof.

The organic liquid may be added to the premixture in an amount of from 0 to 50 wt %, based on the total weight of the premixture. In another embodiment, the optional organic liquid will be added in an amount of from 0 to 10 wt %, based on the total weight of the premixture.

The disclosed method requires that the premixture of the nanoparticle composition (i) and curable binder (ii) be subjected to a high shear dispersion means.

A high shear dispersion means as used herein refers to an attritor, three-roll mill, ball mill, planetary mixer high shear or speed blade mixers such as cowls, and/or ultrasonic mixer each equipped with agitating and heating means and the like. In one exemplary embodiment, the premixture will be subjected to ultrasonic dispersion means or ultrasonic forces, shear mixing, milling and the like. In one exemplary embodiment, the premixture will be subjected to ultrasonic dispersion means or ultrasonic forces.

In one embodiment, the high shear dispersion means will comprise subjecting the premixture to a high shear force that is greater than that obtained via vigorous stirring, i.e., 700-1000 rpm. In one embodiment, a high shear forces is at least 5000 rpm, while in one exemplary embodiment, a high shear force is from 15,000 to 50,000rpm.

The disclosed method requires that the premixture of the nanoparticle composition (i) and the curable binder (ii) be subjected to high shear forces until the nanoparticle composition (i) is sufficiently dispersed into the curable binder (ii) so as to result in a curable composition. It will be appreciated that a curable composition does not result until sufficient dispersion of the nanoparticle composition (i) into the curable binder (ii) occurs.

In one embodiment, a premixture that is 'sufficiently dispersed' as used herein refers to a premixture that after being subjected to high shear forces will pass through a 1 µm filter bag. In another embodiment, a sufficiently dispersed premixture will be a premixture that after being subjected to high shear forces will pass through a 450 nm or .45 µm filter bag.

Alternatively, a sufficiently dispersed premixture will be one that has undergone dispersion equivalent to that experienced by a premixture in an ultrasonification unit such as a Branson 450 digital sonifier system equipped with a double stepped microtip at temperature of 25 °C for a period of 15 to 20 minutes at about 70% power. It will be appreciated that power, temperature and duration will dependent upon the particular sonifier system employed.

Other components discussed above may be added to either the premixture or to the resulting curable composition.

In one embodiment, the disclosed method produces a resulting curable composition, i.e., the disclosed curable compositions, that after curing may be characterized by a coefficient of thermal expansion (CTE) of no more than 60 ppm/°C when cured for a time of from about 20 to about 60 minutes at temperature of from about 100 to 240°C, a modulus of elasticity of at least 4.5 GPa when cured for a time of from about 20 to about 60 minutes at temperature of from about 100 to 240°C, and a glass transition temperature (T_{g}) of at least 80.

The disclosed curable compositions may generally be characterized by a rheology suitable for use in integrated circuit manufacturing processes, especially flip chip manufacturing employing underfill processes. In general, the disclosed curable compositions will be in a liquid phase at least one temperature in a range of from 25°C to 270°C. In one embodiment, the disclosed curable compositions will have a viscosity of from 20 cps to 30,000 cps at a temperature in the range of from 25 to 100°C.

The disclosed compositions may also be characterized by glass transition temperatures (T_{g}) of at least 80°C, while in one embodiment; the disclosed composition will have a T_{g} of less than 250°C. In another exemplary embodiment, the disclosed composition will have T_{g} of from about 150°C to about 190°C, while in an especially exemplary embodiment; the disclosed composition will have T_{g} of from about 155°C to about 175°C.

When cured, the disclosed curable compositions will have a low CTE. CTE as used herein generally refers to the coefficient of thermal expansion as measured before T_{g}, i.e., α₁. The CTE of a cured material may be evaluated using a TMA instrument from TA Instruments, such as Model 2940. CTE is evaluated after the disclosed curable compositions have been applied to a substrate and cured in a reasonable curing profile.

In one embodiment, the curable compositions will have a modulus of elasticity of at least 4.5 GPa when cured for a time of from about 20 to about 60 minutes at temperature of from about 100 to 240°C, in another embodiment, a modulus of at least 5.0 GPa and in one exemplary embodiment at least 6.0 GPa. Modulus may be calculated as described below in the examples.

In general, reasonable curing profiles are those employed in commercial flip chip manufacturing processes. Illustrative reasonable curing profiles include those wherein an applied composition is cured for a time of from about 5 minutes to several hours at temperatures of from about 100 to 240°C, while more preferred reasonable curing profiles include times of from 20 minutes to 60 minutes at temperatures of from 160-220°C. In one exemplary embodiment, the cure profile will be for a time of about 60 minutes at a temperature of about 150°C.

In addition, it will be appreciated by those of skill in the art that reasonable curing profiles may also include post curing. In one particularly exemplary embodiment, the curing profile will comprise solder reflow conditions followed by post curing at a temperature between 120-180°C and preferably at a temperature between 150-170°C or a time of several hours, i.e., 1-4 hours.

The term 'low' CTE as used herein generally refers to CTEs of no more than about 60 ppm/°C. In one embodiment, the disclosed curable compositions will provide a cured composition having a CTE of from 15 to less than 60 ppm/°C. In another embodiment, the disclosed curable compositions will provide a cured composition having a CTE of from 35 to less than 55 ppm/°C. In another exemplary embodiment, the disclosed curable compositions will provide a cured composition having a CTE of from about 40 to about 50 ppm/°C. In one exemplary embodiment, cured compositions having such low CTEs are obtained from the instantly disclosed curable compositions that are substantially free of traditional CTE lowering fillers.

Also disclosed is a method of making an integrated circuit ("IC"), especially a flip chip assembly, using the disclosed curable compositions as well as IC assemblies made from the disclosed method.

A flip chip is a surface mounted chip having connecting metal lines attached to pads on the underside of the chip. A chip or die is mounted on an IC substrate to form an IC assembly. A flip chip may be mounted on a package substrate and the resulting package mounted on a printed circuit board ("PCB"). A flip chip may also be mounted directly to a PCB.

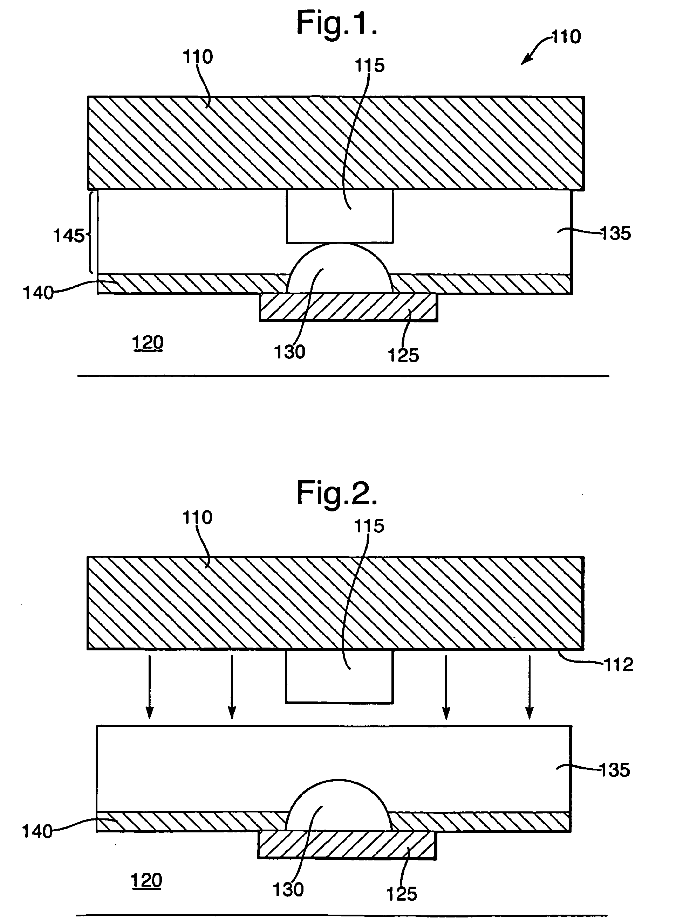

Figure 1 shows a cross-section of one embodiment of an IC assembly 100 as made and disclosed herein. Flip chip die 110 contains a plurality of flip chip bumps on a surface 112, one of which is shown as bump 115. The die 110 is mated to package substrate 120, which contains substrate bump 130 on substrate bump pad 125. A layer of solder resist 140 covers the substrate 120, while a layer of underfill material 135 fills the space 145 between substrate 120 and die 110. It will be appreciated that solder resist 140 is optional only and need not be employed in all embodiments.

In general, the die 110 will have a surface 112 as illustrated in Figure 2. The surface 112 will contain flip chip pads (not shown) and corresponding flip chip bumps 115. Prior to contact with the underfill material 135, the die surface 112 may be covered with an initial passivation layer and then a protective compliant layer, e.g., a thin (ca. 3µm) layer of polyimide.

The flip chip bumps 115 may be of any suitable conductive material, e.g., eutectic SnPb solders, high Pb solders, lead free solders, Sn and Sn alloy solders, and metals such as Cu, Au, Ag, Ni, Sn, or suitable alloys thereof. In one embodiment, the flip chip bumper is copper. Any conventional copper used for IC connections may be used, e.g., by the Damascene process. In one embodiment, the flip chip bump material 115 will have a higher melting point than the substrate or package bump material 130.

The underfill material 135 of the IC assembly 100 in Figure 1 is the curable composition disclosed herein that has been prepared according to the disclosed method and cured as discussed above.

The substrate 120 may be, e.g., a package substrate or PCB. The substrate 120 may include a ceramic, organic or metal core. The substrate 120 generally contains a substrate pad 125 and substrate bumps 130 in locations suitable for electronically mating to corresponding flip chip bumps 115.

The substrate bumps 130 are preferably bumps as discussed above in regards to flip chip bumps 115.

It will be appreciated that in Figures 1-4, the illustrated cross-sections represent one embodiment wherein the flip chip die 110 contains a plurality of bumps 115 and is one of many dies on a wafer. This allows for manufacturing many packages simultaneously. An individual die or wafer containing many dies 110, each with a plurality of bumps 115, may be joined to the package substrate 120.

In one embodiment, the disclosed method of making an IC assembly comprises applying the resulting curable composition from the disclosed method to a substrate 120, placing a die 110 in communication with the applied composition, and curing the applied composition to provide an assembly 100, wherein at least one of the substrate 125 or die 110 comprises one or more bumps 115 or 130. In one exemplary embodiment, both the substrate 125 and the die 110 will both comprise bumps 115 and 130. In one especially exemplary embodiment, the die 110 will be placed in communication with the applied composition such that the bumps 115 touch the bumps 130 and form an interconnection upon reflow of the bumps.

Thus, it will be appreciated that the disclosed method of making a flip chip assembly encompasses both conventional flip chip process employing capillary flow underfill as well as the more advantageous no capillary flow underflow or 'no flow' underfill processes.

In one exemplary embodiment, the disclosed method will employ a no flow underfill process as illustrated in Figure 2. As illustrated in Figure 2, an underfill material 135 has been applied to substrate 120, which comprises substrate bump 130 on substrate bump pad 125.

Various processes may be used to apply underfill material 135 to the wafer or package substrate 120. Examples of such processes include spin-on, dispense, coating (e.g., by brushing or spraying on a liquid), and lamination (e.g., by applying a solid film or sheet). In one embodiment, the underfill material 135 comprising the disclosed curable composition will be applied using a liquid application process such as dispense or coating.

The thickness of the applied underfill 135 is not limited and can be varied for specific applications as needed.

As illustrated in Figure 2, the die 110 is joined to substrate 120 by pressing flip chip bumps 115 through underfill material 135 until flip chip bumps 115 make contact with substrate bumps 130. As noted above, this process can also occur at the wafer level, where the wafer contains a plurality of dies 110 each having a plurality of flip chip bumps 115. Package substrate 120 would then be part of a panel or sheet containing many substrate pads 125 and bumps 130 configured to mate with the flip chip bumps 115 on the wafer.

A chip join process attaches the die 110 to the IC substrate 120. In one embodiment, thermocompressive bonding affects the flip chip join process at the chip level. Alternatively, a wafer level process may be employed. If so, lamination bonding may be used to join a wafer containing applied underfill to a sheet or panel package substrate, e.g., a tape package or flex package.

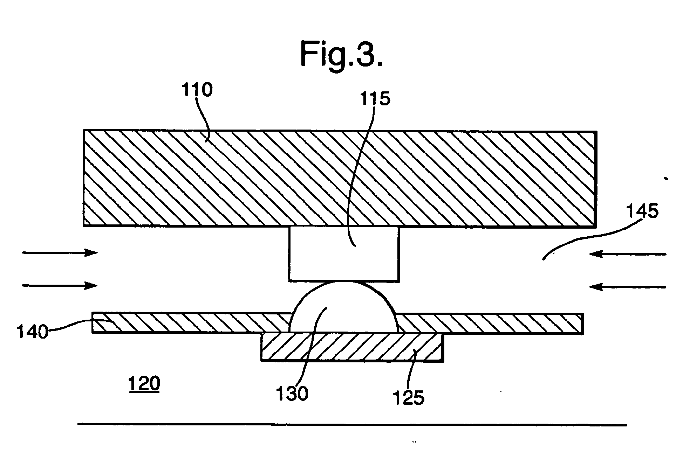

In another embodiment, the disclosed method will employ a capillary flow underfill process as illustrated in Figure 3. As illustrated in Figure 3, an underfill material 135 is injected or dispersed via the direction of the arrows into the space 145 between die 110 and substrate 120. It will be appreciated that this process produces an IC assembly 110 as illustrated in Figure 1.

In one embodiment, the disclosed method will comprise providing a substrate 120 comprising one or more bumps 130 thereon, applying a curable composition 135 to the substrate 120, said curable composition resulting from the disclosed method, placing a die 110 on the applied curable composition , said die 110 comprising one or more bumps 115, subjecting the assembly to a temperature sufficient to cause flow and joining of the bumps, and subjecting the assembly to a temperature sufficient to cause curing of the applied curable composition 135.

In one embodiment, the steps of subjecting the assembly to a temperature sufficient to cause flow of the bumps and subjecting the assembly to a temperature sufficient to cause curing of the applied curable composition 135 occur simultaneously. That is, in this embodiment, the formation of the interconnection between the bumps 115 and 130 as a result of the solder reflow occurs simultaneously with crosslinking in the underfill material 135.

In another embodiment, the bulk of the crosslinking of the curable composition occurs after the onset of solder reflow of the bumps 115 and 130. In this case, the bumps will begin to flow and form the desired interconnection such that the bumps 115 and 130 are joined before crosslinking of the underfill material 135 is completed. In one exemplary embodiment, the crosslinking of the underfill material 135 will progress rapidly once crosslinking begins.

In one embodiment, the disclosed integrated circuit assembly comprises a substrate comprising one or more substrate bumps, a die having an active side comprising one or more flip chip bumps, said die being in communication with the substrate such that the substrate bumps are joined to the flip chip bumps, and a cured composition in communication with the substrate and the die, and surrounding the joined bumps, the cured composition having a CTE of no more than 60 ppm/°C and resulting from the disclosed composition.

The disclosed circuit assemblies may used in a variety of electronic applications given their improvements in interconnection reliability, decreased cost, and resistance to thermal cycling. In one exemplary embodiment, the disclosed integrated circuit assemblies will be used on motor vehicles, especially in applications requiring proximity to vehicle operating temperatures of at least 150°C, such as applications close to or in an internal combustion engine.

### EXAMPLES:

### Example 1

Table 1 provides the short names and chemical compositions of illustrative materials used to make the curable compositions of Tables 2-4.

**Table 1**

| **Product Name** | **Chemical Composition** |
|---|---|
| TGMX | Tetraglycidyl meta-Xylenediamine |
| THPE/GE¹ | 1,1,1-tris(p-hydroxyphenyl)ethane triglycidyl ether |
| Bis F² | Bisphenol F diepoxide |
| APB | 1,3-Bis(3-aminophenoxy)benzene |
| 1,3-4 APB | 1,3-Bis(4-aminophenoxy)benzene |
| 1,4-4 APB | 1,4-Bis(4-aminophenoxy)benzene |
| ASD | 4,4'-diaminodiphenyl sulfide |
| 2,4-DAT | 2,4-diaminotoluene |
| Ancamine Z | A mixture of: 1,3-benzenediamine 4,4'-diaminodiphenyl methane 1-[(3-aminophenyl)amino]-3-phenoxy and 1-[[4-[(4-aminophenyl) methyl] phenyl] amino]-3 phenoxy- |
| Anacamine Y | A mixture of: 4,4'-diaminodiphenyl methane Polymeric methylene dianiline 3,4-diaminotoluene, 2,3-diaminotoluene and 2,4-diaminotolune |
| 1,3-PDA | 1,3-phenylenediamine |
| DAB | Diaminobenzidine |
| 1,5-DAN | 1.5-Diaminonaphtelene |
| 1,8-DAN | 1.5-Diaminonaphtelene |
| MTHPA³ | Methyltetrahydrophthalic anhydride |
| MHHPA³ | Methylhexahydrophthalic anhydride |
| Curezol 2PZ⁴ | 2-phenyl imidazole |
| Curezol 2P4MZ⁴ | 2-phenyl-4-methyl imidazole |
| Catapal™ A⁵ | Synthetic Boehmite |
| Dispal X30CRN⁵ | Catapal functionalized with 4-aminobenzoic acid |
| Dispal X30SRN⁵ | Catapal functionalized with 4-amino benzene sulfonic acid |
| Dispal X30CRN₂⁵ | Catapal functionalized with diaminobenzoic acid |
| Dispal X30SRN₂⁵ | Catapal functionalized with diamino benzene sulfonic acid |
| Catapal™ 10G | Catapal functionalized with glycolic acid at 10 mole percent |
| Catapal™ 50G | Catapal functionalized with glycolic acid at 50 mole percent |
| MgO plus⁶ | Nano-active magnesium oxide plus |

| | |
|---|---|
| ¹Product of DuPont ²Products of Performance Resolution Products ³Products of Lonza Corporation ⁴Products of Air Products and Chemicals ⁵Products of Sasol North America Inc. ⁶Product of Nanoscale Materials Inc. | |

Catapal A™ is a pure alumina hydrate (Boehmite). Dispals are functionalized Boehmites as described in examples of Table 1. Both Catapal™ and Dispal are obtained from Sasol North America Inc. All were dried at 100 - 120°C under vacuum before use. Magnesium oxide particles were obtained from Nanoscale Materials Inc. and were used after drying at 100 - 120°C under vacuum. The epoxy resins used were TGMX, THPE/GE and Bisphenol F (EPM 862) epoxy resins and were obtained from CVC Specialty Chemicals, DuPont, and Resolution Performance Products Corporation, respectively.

Functionalization of Catapal™ was carried out according to the following procedure. Functionalization with glycolic acid is given here as an example. A known weight of Catapal A™ is dispersed in sufficient amount of distilled water. A known amount, which is determined by the desired degree of functionalization, is then added to the Catapal™ suspension (the maximum functionalization possible is 0.5:1.0 mole of Catapal™:carboxylic acid) and the mixture is refluxed for a period of 24-72 hours. The water was then removed by evaporation and the product is washed with acetone. The powder is dried at 100 - 120°C to remove trace amounts of water and stored in a dry place.

The disclosed method requires dispersion of the particular nanoparticle composition into the curable binder by mechanical force such as by ultrasonic forces, shear mixing, or milling. Once uniform nanoparticle dispersion was achieved, the curing agent, along with other ingredients, was added and mixed with the binder/nanoparticle composition. In some cases, nanoparticles were also incorporated in the curing agent side by mechanical force which were then mixed with the epoxy/nanoparticle mixture.

All formulations were degassed before casting and curing was performed at a temperature of 150°C.

Differential scanning calorimetry (DSC) was used to determine the peak maxima of the cure exotherm for all studied formulations. The reported coefficient of thermal expansions and glass transition temperatures were measured by thermomechanical analysis (TMA). Specimens for the TMA analysis were prepared by sanding the cured composition using a #400 grit SiC sand paper.

Illustrative formulations and examples of low CTE epoxy based curable compositions prepared according to the disclosed method are given in Table 2. CTE values of some of the unfilled compositions are also given for comparison.

**Table 2**

| **Formula** | **Resin** | **Curing Agent** | **Nanofiller** | **Wt. %** | **CTE** **(α1)** **ppm/°C** | **Tg** **°C** | **Tmax** **°C** | **Ceramic Yield** **%** |
|---|---|---|---|---|---|---|---|---|
| 1 | TGMX | Ancamine Z | | | 41 | 190 | 176 | |
| 2 | TGMX | Ancamine Y | | | 52 | 170 | 183 | |
| 3 | Bis F | Ancamine Y | | | 74 | 150 | 163 | |
| 4 | TGMX | MHHPA | | | 77 | 130 | 128 | |
| 5 | TGMX | 2P4MZ (6% by wt.) | | | 60 | 150 | 176 | |
| 6 | TGMX | Ancamine Z | Dispal X30CRN | 28 | 36 | 172 | 171 | 21 |
| 7 | TGMX | Ancamine Z | Dispal X30CRN | 38 | 26 | 170 | 168 | 27 |
| 8 | TGMX | Ancamine Z | Dispal X30SRN | 28 | 32 | 175 | 159 | 17 |
| 9 | TGMX | Ancamine Z | Dispal X30CRN₂ | 28 | 35 | 175 | 166 | 19 |
| 10 | TGMX | Ancamine Z | Dispal X30SRN₂ | 28 | 33 | 173 | 162 | 18 |
| 11 | TGMX | Ancamine Z | Catapal A | 38 | 29 | 172 | 167 | 29 |
| 12 | TGMX | Ancamine Z | Catapal A | 28 | 37 | 180 | 171 | 17 |
| 13 | TGMX | Ancamine Y | Dispal X30SRN | 27 | 38 | 180 | 167 | 17 |
| 14 | TGMX | Ancamine Y | Dispal X30CRN | 27 | 39 | 175 | 177 | 18 |
| 15 | TGMX | Ancamine Y | Dispal X30CRN₂ | 27 | 41 | 171 | 177 | 18 |
| 16 | TGMX | Ancamine Y | Catapal A | 27 | 35 | 190 | 186 | 20 |
| 17 | TGMX | Ancamine Y | Catapal A | 36 | 31 | 185 | 176 | 27 |
| 18 | Bis F | Ancamine Y | Catapal A | 29 | 36 | 124 | 152 | 22 |
| 19 | TGMX | Ancamine Y | MgO | 27 | 34 | 170 | 175 | 21 |
| 20 | TGMX | Ancamine Z | MgO | 28 | 32 | 178 | 167 | 22 |
| 21 | | | | | | | | |
| 22 | TGMX | Curezol 2PZ | Catapal A | 33 | 36 | 145 | 169 | 23 |
| 23 | TGMX | Curezol 2P4MZ | Catapal A | 33 | 23 | 150 | 169 | 20 |
| 24 | TGMX | MTHPA/Curezol 2PZ at 1% | Catapal 10G | 39 | 40 | 185 | 150 | 26 |
| 25 | TGMX | MHHPA/Curezol 2PZ at 1% | Catapal 50G | 33 | 38 | 201 | 157 | 18 |
| 26 | TGMX | MTHPA/Curezol 2PZ at 1% | Catapal A | 39 | 34 | 180 | 148 | 30 |
| 27 | TGMX/THPE/GE 1:1 by wt. | Curezol 2PZ at 6% | Catapal A | 24 | 40 | 170 | 128 | 20 |
| 28 | TGMX/THPE/GE 1:1 by Wt. | MHHPA/Curezol 2PZ at 1% | Catapal A | 32 | 41 | 173 | 131 | 27 |
| 29 | 30 | TGMX | Ancamine Z | Hydroxyapatite | 28 | 34 | 180 | 173 |
| | 31 | TGMX | Ancamine Y | Hydroxyapatite | 26 | 43 | 185 | 190 |

### Example 2

### Effect of strongly functionalized nanoparticles on processability.

The premixtures and curable compostions were prepared as indicated in Example 1 according to Table 3 below. Formic acid derivatized boehmite (Catapal X-30F4) was provided by Sasol North America Inc. 2-(2-methoxyethoxy) acetic acid (MEA) and methoxy acetic acid (MA) were obtained commercially (Aldrich) and were used as received.

### Synthesis of MEA-Alumoxane.

In 1L round bottom Flask equipped with a condenser, Catapal X-30F4 (10 g, 166 mmol) was mixed with 450 mL of water and heated until the Catapal was completely dissolved. 2-(2-methoxyethoxy) acetic acid (11.13 g, 83 mmol) was then added and the mixture refluxed for 48 hrs. A distillation apparatus was then placed and ~500 mL of water was distilled along with the free formic acid. The solution was then taken to a rotary evaporator and water was removed in vacuo at 70 °C resulting in a white solid. The obtained solid was dissolved in a minimum amount of CHCl₃ then precipitated in hexane as a white powder. After filtration the product was washed with hexane and dried under vacuum at 60 °C for 24 hrs. The MEA-alumoxane forms nano suspensions in H₂O, CHCl₃, MeOH, and acetone.

### Synthesis of MA-Alumoxane.

Methoxy acetic acid functionalized Alumoxane was synthesized using the same procedure. Catapal X-30F4 (10 g, 166 mmol); methoxy acetic acid (7.47 g, 83 mmol) and 450 mL of water. The resulting MA-Alumoxane forms nano suspensions in H₂O and MeOH.

### Preparation of alumoxane-resin composite by Ultrasonic Force. (Exs 32b and 33 b)

The two carboxylate alumoxanes (1.59g) were ground to a fine powder and added to a glass vial containing the epoxy resin TGMX (3 g). The mixtures were then stirred mechanically and then placed in a Branson 450 digital sonifier system. The composite was sonicated using a microtip for 20 minutes under N₂ to yield a highly viscous, hard to process resin in both cases.

### Preparation of alumoxane-resin composite through the Formation of Organosol. (Exs 32a and 33a)

In a beaker equipped with a magnetic stirrer, 1.59g of MEA-Alumoxane was mixed with 20-30 mL of chloroform. The mixture was stirred until an organosol suspension is formed. 3g of TGMX epoxy resin was then added to the organosol with additional mixing. The chloroform was then removed completely from the composition using Rotavapor at 60°C. A similar composition was obtained from MA-Alumoxane using methanol instead of chloroform.

Table 3 illustrates the effect of strongly functionalized nanoparticles upon processability.

**Table 3**

| **Processability of Underfill Nanocompositions.** | | | | | | |
|---|---|---|---|---|---|---|
| **Formula** | **Resin** | **Curing Agent** | **Nanofiller** | **Wt. %** | **Modulus at 25°C (GPa)** | **Modulus at 150°C (GPa)** |
| 1 | TGMX | Ancamine Z | | | 3.9 | 2.5 |
| 6 | TGMX | Ancamine Z | Dispal X30CRN | 28 | 6.2 | 4.0 |
| 11 | TGMX | Ancamine Z | Catapal A | 38 | 6.6 | 4.6 |
| 29 | TGMX | Ancamine Z | Catapal A | 32 | 6.1 | 3.9 |
| 30 | TGMA | Ancamine Z | Hydroxyapatite | 28 | 6.3 | 3.9 |
| 2 | TGMX | Ancamine Y | | | 3.8 | 2.2 |
| 17 | TGMX | Ancamine Y | Catapal A | 36 | 8.1 | 5.4 |
| 31 | TGMX | Ancamine Y | Hydroxyapatite | 26 | 5.5 | 3.5 |
| 5 | TGMX | 2P4MZ (6% by wt.) | | | 3.2 | 1.0 |
| 23 | TGMX | Curezol 2P4MZ | Catapal A | 33 | 6.5 | 2.1 |

### Example 3.

### Effect of Nanoparticle composition (i) on Modulus

The modulus of elasticity was calculated for various formulations in Example 1. It can be seen that use of the disclosed methods results in curable compositions having a higher modulus. Modulus was calculated using a DMA 2980 (TA Instruments) at a frequency of 1 hertz with a single cantilever fixture.

**Table 4**

| **Formula** | **Resin** | **Functionalized Nanofiller** | **Wt. %** | **Method of Mixing** | **Processable** |
|---|---|---|---|---|---|
| 32a | TGMX | Alumoxane of 2-(2-methoxyethoxy) acetic acid | 28 | Cholorform Nano-dispersion | No |
| 32b | TGMX | Alumoxane of 2-(2-methoxyethoxy) acetic acid | 28 | Ultrasonic | No |
| 33a | TGMX | Alumoxane of methoxy acetic acid | 28 | Methanol Nano-dispersion | No |
| 33b | TGMX | Alumoxane of methoxy acetic acid | 28 | Ultrasonic | No |

## Claims

1. A method of making a low CTE curable composition, the method comprising:
mixing together
(i) from 10 to 45.0 % by weight of a nanoparticle composition (i) comprising at least one of magnesium oxide nanoparticles, boehmite nanoparticles, hydroxyapatite powder or a combination comprising two or more of the foregoing and having an average particle size of from 1 to 100 nm when dispersed and which is at least one of
(a) a strongly functionalized nanoparticle composition functionalized with a carboxylic acid having at least one strongly functionalizing substituent group selected from the group consisting of a aromatic mono primary amine group, an aliphatic mono or di primary amine group, an aliphatic dihydroxyl of the formula (-CR(XOH)₂ wherein R is a C₁₋₅ alkyl group or H, X is CH₂ or an aromatic group, and n is 0 for 1), a phenol group, an alkoxy group, or mixtures thereof, and having less than or equal to 25 mole % functionalization,
(b) a weakly functionalized nanoparticle composition functionalized with a mono hydroxyl substituted carboxylic or mono hydroxyl substituted sulfonic acid group and having from 1 to 50 mole % functionalization,
(c) a nonfunctionalized nanoparticle composition, or
(d) mixtures thereof, with the proviso that the nanoparticles composition (i) comprises at least 51% by weight of nonfunctionalized nanoparticles composition (c),
(ii) from 20.0 to 90.0% by weight of a curable binder (ii) to provide a premixture, based on the total weight of the premixture, and wherein the curable composition is **characterized by**:
(1.) a coefficient of thermal expansion (CTE) of no. more than 60 ppm/°C, when cured for a time of from about 20 to about 60 minutes at temperature of from about 100 to 240°C,
(2.) a modulus of elasticity of no less than 4.50 GPa when cured for a time of from about 20 to about 60 minutes at temperature of from about 100 to 240°C, and
(3.) a glass transition temperature of no less than 80°C, and subjecting the premixture to high shear forces until the nanoparticle composition (i) is sufficiently dispersed in the curable binder (ii) to provide a curable composition.

2. The method of claim 1 wherein the nanoparticle composition (i) comprises at least one of magnesium oxide nanoparticles, boehmite nanoparticles, hydroxyapatite powder or a combination comprising two or more of the foregoing.

3. The method of claim 1 wherein the nanoparticle composition (i) consists of nonfunctionalized nanoparticle composition (c).

4. The method of claim 1 wherein the nanoparticle composition (i) consists of strongly functionalized nanoparticle composition (a).

5. The method of claim 1 wherein the nanoparticle composition (i) consists of weakly functionalized nanoparticle composition (b).

6. The method of claim 4 wherein the functionalized nanoparticle composition (a) is a crosslinking agent for the curable binder (ii).

7. The method of claim 1 comprising mixing together from 1 to 50 % by weight of the nanoparticle composition (i), based on the total weight of the premixture.

8. The method of claim 7 comprising mixing together from 10 to 45 % by weight of the nanoparticle composition (i), based on the total weight of the premixture.

9. The method of claim 8 comprising mixing together from 25 to 45 % by weight of the nanoparticle composition (i), based on the total weight of the premixture.

10. The method of claim 1 wherein the curable binder (ii) comprises at least one epoxy compound of the structure:
X-((CH₂)ₘ-(N)-((CH₂)ₙ-(Z))₂)ₚ
wherein X is an aromatic ring or a six membered cycloaliphatic ring, m is from 0 to 2, n is from 1 to 3, Z is an epoxy group of empirical formula C₂H₃O, p is a number from 2 to 3.

11. The method of claim 10 wherein the curable binder (ii) comprises at least one epoxy compound of the structure:
X-((CH₂)ₘ-(N)-((CH₂)ₙ-(Z))₂)ₚ
wherein X is an aromatic ring, m is from 0 to 1, and n is from 1 to 2.

12. The method of claim 11 wherein the at least one epoxy compound is N, N, N', N'-tetraglycidyl-*meta*-xylenediamine.

13. The method of claim 1 further comprising a crosslinking agent (iib).

14. The method of claim 13 wherein the crosslinking agent (iib) comprises at least one polyamine comprising from 2 to 4 primary amine groups.

15. The method of claim 1 wherein the crosslinking agent (iib) comprises at least one polyamine of the structure:
(R)ₚ-(NH₂)_{q}
wherein R is at least one of a substituted or unsubstituted aromatic ring, a substituted or unsubstituted six membered cycloaliphatic ring, a substituted or unsubstituted heteroaromatic ring, a substituted or unsubstituted six membered cycloheteroaliphatic ring, (R₁-W)ₖ-R₂, (R₁-W-R₂)ₖ, and combinations thereof, p
is from 1 to 4, and q is from 2 to 4, wherein R₁ and R₂ are the same or different and are defined as R above, W is at least one of, an alkyl group of from 1 to 3 carbons, a heteroatom, a heteroatom containing radical, and combinations thereof, and k is from 1 to 4,

16. The method of claim 1 further comprising a catalyst (v).

17. The method of claim 1 further comprising adding an organic liquid (iii) to the premixture.

18. The method of claim 17 wherein the organic liquid (iii) is a solvent for the curable binder (ii).

19. The method of claim 18 wherein the organic liquid (iii) is at least one of methanol, ethanol, acetone, methylethyl ketone, tetrahydrofuran, chloroform, butyl acetate, toluene and mixtures thereof.

20. The method of claim 1 further comprising adding at least one of additives, accelerators, diluents, coupling agents, adhesion agents, fluxing agents, impact modifiers, aliphatic amines, stabilizers, antioxidants, antifoaming agents, flame retardants, and combinations comprising two or more of the foregoing to either the premixture or the curable composition.

21. A curable composition comprising
(i) from 10 to 45.0 % by weight of a nanoparticle composition (i) comprising at least one of magnesium oxide nanoparticles, boehmite nanoparticles, hydroxyapatite powder or a combination comprising two or more of the foregoing and having an average particle size of from 1 to 100 nm when dispersed and which is at least one of
(a) a strongly functionalized nanoparticle composition functionalized with a carboxylic acid having at least one strongly functionalizing substituent group selected from the group consisting of a aromatic mono primary amine group, an aliphatic mono or di primary amine group, an aliphatic dihydroxyl of the formula (-CR(XOH)₂ wherein R is a C₁₋₅ alkyl group or H, X is CH₂ or an aromatic group, and n is 0 or 1), a phenol group, an alkoxy group, or mixtures thereof, and having less than or equal to 25 mole % functionalization,
(b) a weakly functionalized nanoparticle composition functionalized with a mono hydroxyl substituted carboxylic or mono hydroxyl substituted sulfonic acid group and having from 1 to 50 mole % functionalization,
(c) a nonfunctionalized nanoparticle composition, or
(d) mixtures thereof, with the proviso that the nanoparticles composition (i) comprises at least 51% by weight of nonfunctionalized nanoparticles composition (c), and
(ii) from 20.0 to 90.0 % by weight of a curable binder (ii), based on the total weight of the curable composition,
wherein the curable composition is **characterized by** :
(1.) a coefficient of thermal expansion (CTE) of no more than 60 ppm/°C when cured for a time of from about 20 to about 60 minutes at temperature of from about 100 to 240°C,
(2.) a modulus of elasticity of no less than 4.50 GPa when cured for a time of from about 20 to about 60 minutes at temperature of from about 100 to 240°C, and
(3.) a glass transition temperature of no less than 80°C.

22. A method of making a low CTE cured composition, the method comprising
applying the curable composition of claim 21 to a substrate to provide a coated substrate, and
curing the coated substrate to provide a cured composition having a coefficient of thermal expansion (CTE) of no more than 60 ppm/°C.

23. The method of claim 22 comprising curing the coated substrate for a time of from 20 to 60 minutes at temperature of from 100 to 240°C.

24. A method of making an integrated circuit assembly (100), comprising
applying the curable composition made by the method of claim 1 to a substrate,
placing a die in communication with the applied composition, and
curing the applied composition to provide an integrated circuit assembly (100),
wherein at least one of the substrate or die comprises one or more bumps (115).

25. The integrated circuit made by the method of claim 24 comprising a cured composition having a CTE of from 35 to 50 ppm/°C.

26. A method of making an integrated circuit comprising
providing a substrate comprising one or more substrate bumps (115) thereon,
applying the curable composition made by the method of claim 1 to the substrate,
placing a die (110) on the applied curable composition, said die (110) comprising one or more flip chip bumps,
subjecting the assembly (100) to a temperature sufficient to cause flow and joining of the bumps (115), and
subjecting the assembly (100) to a temperature sufficient to cause curing of the applied curable composition.

27. The method of claim 26 wherein the steps of subjecting the assembly (100) to a temperature sufficient to cause flow of the bumps (115) and subjecting the assembly (100) to a temperature sufficient to cause crosslinking of the applied curable composition occur simultaneously.

28. The method of claim 26 wherein the majority of the crosslinking of the curable composition occurs after the step of subjecting the assembly (100) to a temperature sufficient to cause flow of the bumps (115).

## Patentansprüche

1. Verfahren zur Herstellung einer härtbaren Zusammensetzung mit niedrigem CTE, wobei das Verfahren aufweist:
Zusammenmischen
(i) von 10 bis 45,0 Gewichtsprozent einer Nanopartikelzusammensetzung (i), die zumindest eines aufweist aus Magnesiumoxid-Nanopartikeln, Boehmit-Nanopartikeln, Hydroxyapatit-Pulver oder einer Kombination, die zwei oder mehr der vorhergehenden aufweist, und eine mittlere Partikelgröße von 1 bis 100 nm hat, wenn dispergiert, und zumindest eines ist aus
(a) einer stark funktionalisierten Nanopartikelzusammensetzung, funktionalisiert mit einer Karbonsäure mit zumindest einer stark funktionalisierenden Substituentengruppe, gewählt aus der Gruppe, die besteht aus einer aromatischen Monoprimär-Amin-Gruppe, einer aliphatischen Mono- oder Di-primär-Amin-Gruppe, einem aliphatischen Dihydroxyl der Formel (-CR(XOH)₂, wobei R eine C₁₋₅ Alkyl-Gruppe oder H ist, X CH₂ oder eine aromatische Gruppe ist, und n 0 oder 1 ist), einer Phenol-Gruppe, einer AlkoxyGruppe oder Mischungen davon ist, und weniger oder gleich 25 Mol % Funktionalisierung hat,
(b) einer schwach funktionalisierten Nanopartikelzusammensetzung, funktionalisiert mit einer Mono-Hydroxyl substituierten Carbonsäure- oder Mono-Hydroxyl substituierten Sulfonsäure-Gruppe, mit einer 1 bis 50 Mol % Funktionalisierung,
(c) einer nichtfunktionalisierten Nanopartikelzusammensetzung, oder
(d) Mischungen davon, mit der Bedingung, dass die Nanopartikelzusammensetzung (i) zumindest 51 Gewichtsprozent einer nichtfunktionalisierten Nanopartikelzusammensetzung (c) aufweist,
(ii) von 20,0 bis 90,0 Gewichtsprozent eines härtbaren Binders (ii), um eine Vormischung vorzusehen, basierend auf dem Gesamtgewicht der Vormischung, und
wobei die härtbare Zusammensetzung **gekennzeichnet ist durch**:
(1.) einen Wärmeausdehnungskoeffizient (CTE - coefficient of thermal expansion) von nicht mehr als 60 ppm/°C, wenn gehärtet für eine Dauer von ungefähr 20 bis ungefähr 60 Minuten bei einer Temperatur von ungefähr 100 bis 240 °C,
(2.) ein Elastizitätsmodul von nicht weniger als 4,50 GPa, wenn gehärtet für eine Dauer von ungefähr 20 bis ungefähr 60 Minuten bei einer Temperatur von ungefähr 100 bis 240 °C, und
(3.) eine Glasübergangstemperatur von nicht weniger als 80 °C, und
Unterziehen der Vormischung hohen Scherkräften, bis die Nanopartikelzusammensetzung (i) in dem härtbaren Binder (ii) ausreichend dispergiert ist, um eine härtbare Zusammensetzung vorzusehen.

2. Verfahren gemäß Anspruch 1, wobei die Nanopartikelzusammensetzung (i) zumindest eines aufweist aus Magnesiumoxid-Nanopartikeln, Boehmit-Nanopartikeln, Hydroxyapatit-Pulver oder einer Kombination, die zwei oder mehr der vorhergehenden aufweist.

3. Verfahren gemäß Anspruch 1, wobei die Nanopartikelzusammensetzung (i) aus einer nichtfunktionalisierten Nanopartikelzusammensetzung (c) besteht.

4. Verfahren gemäß Anspruch 1, wobei die Nanopartikelzusammensetzung (i) aus einer stark funktionalisierten Nanopartikelzusammensetzung (a) besteht.

5. Verfahren gemäß Anspruch 1, wobei die Nanopartikelzusammensetzung (i) aus einer schwach funktionalisierten Nanopartikelzusammensetzung (b) besteht.

6. Verfahren gemäß Anspruch 4, wobei die funktionalisierte Nanopartikelzusammensetzung (a) ein Vernetzungsmittel für den härtbaren Binder (ii) ist.

7. Verfahren gemäß Anspruch 1, das aufweist Zusammenmischen von 1 bis 50 Gewichtsprozent der Nanopartikelzusammensetzung (i), basierend auf dem Gesamtgewicht der Vormischung.

8. Verfahren gemäß Anspruch 7, das aufweist Zusammenmischen von 10 bis 45 Gewichtsprozent der Nanopartikelzusammensetzung (i), basierend auf dem Gesamtgewicht der Vormischung.

9. Verfahren gemäß Anspruch 8, das aufweist Zusammenmischen von 25 bis 45 Gewichtsprozent der Nanopartikelzusammensetzung (i), basierend auf dem Gesamtgewicht der Vormischung.

10. Verfahren gemäß Anspruch 1, wobei der härtbare Binder (ii) aufweist zumindest eine Epoxidverbindung der Struktur:
X-((CH₂)ₘ-(N)-((CH₂)ₙ-(Z))₂)ₚ
wobei X ein aromatischer Ring oder ein sechs-gliedriger cycloaliphatischer Ring ist, m von 0 bis 2 ist, n von 1 bis 3 ist, Z eine Epoxid-Gruppe der empirischen Formel C₂H₃O ist, p eine Zahl von 2 bis 3 ist.

11. Verfahren gemäß Anspruch 10, wobei der härtbare Binder (ii) aufweist zumindest eine Epoxidverbindung der Struktur:
X-((CH₂)ₘ-(N)-((CH₂)ₙ-(Z))₂)ₚ
wobei X ein aromatischer Ring ist, m von 0 bis 1 ist, und n von 1 bis 2 ist.

12. Verfahren gemäß Anspruch 11, wobei die zumindest eine Epoxidverbindung N, N, N', N'-Tetraglycidyl-meta-xylendiamin ist.

13. Verfahren gemäß Anspruch 1, das weiter ein Vernetzungsmittel (iib) aufweist.

14. Verfahren gemäß Anspruch 13, wobei das Vernetzungsmittel (iib) zumindest ein Polyamin aufweist, das von 2 bis 4 primäre Amin-Gruppen aufweist.

15. Verfahren gemäß Anspruch 1, wobei das Vernetzungsmittel (iib) aufweist zumindest ein Polyamin der Struktur:
(R)ₚ-(NH₂)_{q}
wobei R zumindest einer ist eines substituierten oder unsubstituierten aromatischen Ringes, eines substituierten oder unsubstituierten sechs-gliedrigen cycloaliphatischen Ringes, eines substituierten oder unsubstituierten heteroaromatischen Ringes, eines substituierten oder unsubstituierten sechs-gliedrigen cycloheteroaliphatischen Ringes, (R₁-W)ₖ-R₂, (R₁-W-R₂)ₖ, und Kombinationen davon, p von 1 bis 4 ist, und q von 2 bis 4 ist, wobei R₁ und R₂ gleich oder unterschiedlich sind und definiert sind als R oben, W zumindest eines ist aus einer Alkyl-Gruppe von 1 bis 3 Kohlenstoffen, einem Heteroatom, einem Heteroatom, das ein Radikal enthält, und Kombinationen davon, und k von 1 bis 4 ist.

16. Verfahren gemäß Anspruch 1, das weiter einen Katalysator (v) aufweist.

17. Verfahren gemäß Anspruch 1, das weiter aufweist ein Hinzufügen einer organischen Flüssigkeit (iii) zu der Vormischung.

18. Verfahren gemäß Anspruch 17, wobei die organische Flüssigkeit (iii) ein Lösungsmittel für den härtbaren Binder (ii) ist.

19. Verfahren gemäß Anspruch 18, wobei die organische Flüssigkeit (iii) zumindest eines ist aus Methanol, Ethanol, Aceton, Methylethylketon, Tetrahydrofuran, Chloroform, Butylacetat, Toluol und Mischungen davon.

20. Verfahren gemäß Anspruch 1, das weiter aufweist ein Hinzufügen zumindest eines aus Additiven, Beschleunigern, Verdünnungsmitteln, Haftvermittlern, Adhäsionsmitteln, Schmelzmitteln, Schlagmodifizierungsmitteln, aliphatischen Aminen, Stabilisatoren, Antioxydantien, Antischaummitteln, Flammschutzmitteln und Kombinationen, die zwei oder mehr der vorhergehenden aufweisen, entweder zu der Vormischung oder der härtbaren Zusammensetzung.

21. Härtbare Zusammensetzung, die aufweist:
(i) von 10 bis 45,0 Gewichtsprozent einer Nanopartikelzusammensetzung (i), die zumindest eines aufweist aus Magnesiumoxid-Nanopartikeln, Boehmit-Nanopartikeln, Hydroxyapatit-Pulver oder einer Kombination, die zwei oder mehr der vorhergehenden aufweist, und eine mittlere Partikelgröße von 1 bis 100 nm hat, wenn dispergiert, und zumindest eines ist aus
(a) einer stark funktionalisierten Nanopartikelzusammensetzung, funktionalisiert mit einer Karbonsäure mit zumindest einer stark funktionalisierenden Substituentengruppe, gewählt aus der Gruppe, die besteht aus einer aromatischen Monoprimär-Amin-Gruppe, einer aliphatischen Mono- oder Di-primär-Amin-Gruppe, einem aliphatischen Dihydroxyl der Formel (-CR(XOH)₂, wobei R eine C₁₋₅ Alkyl-Gruppe oder H ist, X CH₂ oder eine aromatische Gruppe ist, und n 0 oder 1 ist), einer Phenol-Gruppe, einer AlkoxyGruppe oder Mischungen davon ist, und weniger oder gleich 25 Mol % Funktionalisierung hat,
(b) einer schwach funktionalisierten Nanopartikelzusammensetzung, funktionalisiert mit einer Mono-Hydroxyl substituierten Carbonsäure- oder Mono-Hydroxyl substituierten Sulfonsäure-Gruppe, mit einer 1 bis 50 Mol % Funktionalisierung,
(c) einer nichtfunktionalisierten Nanopartikelzusammensetzung, oder
(d) Mischungen davon, mit der Bedingung, dass die Nanopartikelzusammensetzung (i) zumindest 51 Gewichtsprozent einer nichtfunktionalisierten Nanopartikelzusammensetzung (c) aufweist,
(ii) von 20,0 bis 90,0 Gewichtsprozent eines härtbaren Binders (ii), basierend auf dem Gesamtgewicht der härtbaren Zusammensetzung,
wobei die härtbare Zusammensetzung **gekennzeichnet ist durch**:
(1.) einen Wärmeausdehnungskoeffizient (CTE - coefficient of thermal expansion) von nicht mehr als 60 ppm/°C, wenn gehärtet für eine Dauer von ungefähr 20 bis ungefähr 60 Minuten bei einer Temperatur von ungefähr 100 bis 240 °C,
(2.) ein Elastizitätsmodul von nicht weniger als 4,50 GPa, wenn gehärtet für eine Dauer von ungefähr 20 bis ungefähr 60 Minuten bei einer Temperatur von ungefähr 100 bis 240 °C, und
(3.) eine Glasübergangstemperatur von nicht weniger als 80 °C.

22. Verfahren zur Herstellung einer härtbaren Zusammensetzung mit niedrigem CTE, wobei das Verfahren aufweist
Aufbringen der härtbaren Zusammensetzung gemäß Anspruch 21 auf ein Substrat, um ein überzogenes bzw. beschichtetes Substrat vorzusehen, und Härten des überzogenen Substrats, um eine gehärtete Zusammensetzung vorzusehen, die einen Wärmeausdehnungskoeffizient (CTE- coefficient of thermal expansion) von nicht mehr als 60 ppm/°C hat.

23. Verfahren gemäß Anspruch 22, das aufweist ein Härten des überzogenen Substrats für eine Dauer von 20 bis 60 Minuten bei einer Temperatur von 100 bis 240 °C.

24. Verfahren zur Herstellung eines integrierten Schaltungsaufbaus (100), das aufweist
Aufbringen der härtbaren Zusammensetzung, hergestellt durch das Verfahren gemäß Anspruch 1, auf ein Substrat,
Platzieren eines Dies bzw. Chips in Verbindung mit der aufgebrachten Zusammensetzung, und
Härten der aufgebrachten Zusammensetzung, um einen integrierten Schaltungsaufbau (100) vorzusehen,
wobei zumindest das Substrat oder der Die einen oder mehrere Bumps bzw. Kontakthöcker (115) aufweist.

25. Integrierte Schaltung, hergestellt durch das Verfahren gemäß Anspruch 24, die eine gehärtete Zusammensetzung mit einem CTE von 35 bis 50 ppm °C aufweist.

26. Verfahren zur Herstellung einer integrierten Schaltung, das aufweist Vorsehen eines Substrats, das einen oder mehrere Substrat-Bumps (115) darauf aufweist,
Aufbringen der härtbaren Zusammensetzung, hergestellt durch das Verfahren gemäß Anspruch 1, auf das Substrat,
Platzieren eines Dies (110) auf der aufgebrachten härtbaren Zusammensetzung, wobei der Die (110) einen oder mehrere Flip-Chip-Bumps aufweist,
Aussetzen des Aufbaus (100) einer Temperatur, die ausreichend ist, um ein Fließen und ein Verbinden der Bumps (115) zu veranlassen, und Aussetzen des Aufbaus (100) einer Temperatur, die ausreichend ist, um ein Härten der aufgebrachten härtbaren Zusammensetzung zu veranlassen.

27. Verfahren gemäß Anspruch 26, wobei die Schritte des Aussetzens des Aufbaus (100) einer Temperatur, die ausreichend ist, um ein Fließen der Bumps (115) zu veranlassen, und des Aussetzens des Aufbaus (100) einer Temperatur, die ausreichend ist, um eine Vernetzung der aufgebrachten härtbaren Zusammensetzung zu verursachen, gleichzeitig stattfinden.

28. Verfahren gemäß Anspruch 26, wobei der größte Teil der Vernetzung der härtbaren Zusammensetzung stattfindet nach dem Schritt des Aussetzens des Aufbaus (100) einer Temperatur, die ausreichend ist, um ein Fließen der Bumps (115) zu veranlassen.

## Revendications

1. Procédé de production d'une composition durcissable à faible coefficient de dilatation thermique (CTE), ce procédé comprenant :
Le mélange
(i) de 10 à 45,0% en poids d'une composition nanoparticulaire (i) comprenant au moins un élément parmi des nanoparticules d'oxyde de magnésium, nanoparticules de boehmite, poudre d'hydroxyapatite ou une combinaison comprenant deux ou plus des éléments susvisés et présentant une taille particulaire moyenne allant de 1 à 100 nm en état de dispersion et qui est au moins une des compositions suivantes
(a) une composition nanoparticulaire fortement fonctionnalisée par un acide carboxylique présentant au moins un groupe substituant à fort effet fonctionnalisant sélectionné à partir du groupe constitué d'un groupe amine aromatique primaire mono, d'un groupe amine aliphatique primaire mono ou di, d'un di-hydroxyle aliphatique de formule (-CR(XOH)₂ où R est un groupe alkyle en C₁₋₅ ou H, X est du CH₂ ou un groupe aromatique, et n est 0 ou 1), d'un groupe phénol, d'un groupe alcoxy ou de mélanges de ceux-ci et présentant une fonctionnalisation inférieure ou égale à 25% molaire,
(b) une composition nanoparticulaire faiblement fonctionnalisée par un groupe carboxylique hydroxyle mono substitué ou un groupe acide sulfonique hydroxyle monosubstitué et présentant une fonctionnalisation de 1 à 50 % molaire,
(c) une composition nanoparticulaire non fonctionnalisée, ou
(d) des mélanges de celles-ci, à condition que la composition de nanoparticules (i) comprenne au moins 51 % en poids de la composition nanoparticulaire non fonctionnalisée (c),
(ii) de 20,0 à 90,0% en poids d'un liant durcissable (ii) afin de produire un pré-mélange , sur la base du poids total du pré-mélange et où la composition durcissable est **caractérisée par** :
(1.) un coefficient de dilatation thermique (coefficient of thermal expansion - CTE) ne dépassant pas 60 ppm/°C pour une cuisson d'environ 20 à environ 60 minutes à une température d'environ 100 à 240°C,
(2.) un module d'élasticité d'au moins 4,50 GPa pour une cuisson d'environ 20 à environ 60 minutes à une température d'environ 100 à 240°C, et
(3.) une température de transition vitreuse d'au moins 80°C, et
la soumission du pré-mélange à de fortes forces de cisaillement jusqu'à ce que la composition nanoparticulaire (i) soit suffisamment dispersée dans le liant durcissable (ii) pour produire une composition durcissable.

2. Procédé de la revendication 1 où la composition nanoparticulaire (i) comprend au moins un élément parmi des nanoparticules d'oxyde de magnésium, nanoparticules de boehmite, poudre d'hydroxyapatite ou une combinaison comprenant deux ou plusieurs des éléments suscités.

3. Procédé de la revendication 1 où la composition nanoparticulaire (i) consiste en une composition nanoparticulaire non fonctionnalisée (c).

4. Procédé de la revendication 1 où la composition nanoparticulaire (i) consiste en la composition nanoparticulaire fortement fonctionnalisée (a).

5. Procédé de la revendication 1 où la composition nanoparticulaire (i) consiste en la composition nanoparticulaire faiblement fonctionnalisée (b).

6. Procédé de la revendication 4 où la composition nanoparticulaire fonctionnalisée (a) est un agent de réticulation pour le liant durcissable (ii).

7. Procédé de la revendication 1 comprenant le mélange de 1 à 50% en poids de la composition nanoparticulaire (i), sur la base du poids total du pré-mélange.

8. Procédé de la revendication 7 comprenant le mélange de 10 à 45% en poids de la composition nanoparticulaire (i), sur la base du poids total du pré-mélange.

9. Procédé de la revendication 8 comprenant le mélange de 25 à 45% en poids de la composition nanoparticulaire (i), sur la base du poids total du pré-mélange.

10. Procédé de la revendication 1 où le liant durcissable (ii) comprend au moins un composé époxy conforme à la structure :
X-((CH₂)ₘ-(N)-((CH₂)ₙ-(Z))₂)ₚ
Où X est un noyau aromatique ou un noyau cyclo-aliphatique à six branches, m est une valeur de 0 à 2, n est une valeur de 1 à 3, Z est un groupe époxy de formule empirique C₂H₃O, p est un nombre de 2 à 3.

11. Procédé de la revendication 10 où le liant durcissable (ii) comprend au moins un composé époxy conforme à la structure :
X-((CH₂)ₘ-(N)-((CH₂)ₙ-(Z))₂)ₚ
Où X est un noyau aromatique, m est une valeur de 0 à 1 et n est une valeur de 1 à 2.

12. Procédé de la revendication 11 où le dit au moins un composé époxy est une N,N,N',N'-tétraglycidyl-*méta*-xylènediamine.

13. Procédé de la revendication 1 comprenant en outre un agent de réticulation (iib).

14. Procédé de la revendication 13 où l'agent de réticulation (iib) comprend au moins une polyamine comprenant de 2 à 4 groupes amines primaires.

15. Procédé de la revendication 1 où l'agent de réticulation (iib) comprend au moins une polyamine conforme à la structure :
(R)ₚ-(NH₂)_{q}
Où R est au moins un élément parmi un noyau aromatique substitué ou non substitué, un anneau cyclo-aliphatique à six branches substitué ou non substitué, un anneau hétéro-aromatique substitué ou non substitué, un anneau cyclo-hétéroaliphatique à six branches substitué ou non substitué, (R₁-W)ₖ-R₂, (R₁-W-R₂)ₖ, et des combinaisons de ceux-ci, p est une valeur de 1 à 4, et q est une valeur de 2 à 4, où R₁ et R₂ sont identiques ou différents et sont définis comme R ci-dessus, W est au moins un élément parmi un groupe alkyle ayant de 1 à 3 carbones, un hétéroatome, un radical contenant un hétéroatome et des combinaisons de ceux-ci, et k est une valeur de 1 à 4.

16. Procédé de la revendication 1 comprenant en outre un catalyseur (v).

17. Procédé de la revendication 1 comprenant en outre l'ajout au pré-mélange d'un liquide organique (iii).

18. Procédé de la revendication 17 où le liquide organique (iii) est un solvant pour le liant durcissable (ii).

19. Procédé de la revendication 18 où le liquide organique (iii) est au moins un élément parmi les éléments méthanol, éthanol, acétone, méthyle-éthyle-cétone, tétrahydrofurane, chloroforme, acétate de butyle, toluène et des mélanges de ceux-ci.

20. Procédé de la revendication 1 comprenant en outre l'ajout soit au pré-mélange soit à la composition durcissable d'au moins un élément parmi les éléments additifs, accélérateurs, diluants, agents de couplage, agents d'adhérence, agents fondants , modificateurs d'impact, amines aliphatiques, stabilisateurs, antioxydants, agents anti-mousse, retardateurs de flamme et des combinaisons comprenant deux ou plus des éléments suscités.

21. Composition durcissable comprenant
(i) de 10 à 45,0% en poids d'une composition nanoparticulaire (i) comprenant au moins un élément parmi des nanoparticules d'oxyde de magnésium, nanoparticules de boehmite, poudre d'hydroxyapatite ou une combinaison comprenant deux ou plus des éléments susvisés et présentant une taille particulaire moyenne allant de 1 à 100 nm en état de dispersion et qui est au moins une des compositions suivantes
(a) une composition nanoparticulaire fortement fonctionnalisée par un acide carboxylique présentant au moins un groupe substituant à fort effet fonctionnalisant sélectionné à partir du groupe constitué d'un groupe amine aromatique primaire mono, d'un groupe amine aliphatique primaire mono ou di, d'un di-hydroxyle aliphatique de formule (-CR(XOH)₂ où R est un groupe alkyle en C₁₋₅ ou H, X est du CH₂ ou un groupe aromatique, et n est 0 ou 1), d'un groupe phénol, d'un groupe alcoxy ou de mélanges de ceux-ci et présentant une fonctionnalisation inférieure ou égale à 25% molaire,
(b) une composition nanoparticulaire faiblement fonctionnalisée par un groupe carboxylique hydroxyle monosubstitué ou d'un groupe acide sulfonique hydroxyle monosubstitué et présentant une fonctionnalisation de 1 à 50 % molaire,
(c) une composition nanoparticulaire non fonctionnalisée ou
(d) des mélanges de celles-ci, à condition que la composition de nanoparticules (i) comprenne au moins 51 % en poids de la composition nanoparticulaire non fonctionnalisée (c), et
(ii) de 20,0 à 90,0% en poids d'un liant durcissable (ii), sur la base du poids total de la composition durcissable , où la composition durcissable est
**caractérisée par** :
(1.) un coefficient de dilatation thermique (coefficient of thermal expansion - CTE) ne dépassant pas 60 ppm/°C pour une cuisson d'environ 20 à environ 60 minutes à une température d'environ 100 à 240°C,
(2.) un module d'élasticité d'au moins 4,50 GPa pour une cuisson d'environ 20 à environ 60 minutes à une température d'environ 100 à 240°C, et
(3.) une température de transition vitreuse d'au moins 80°C.

22. Procédé de production d'une composition durcie à faible coefficient CTE, procédé comprenant
L'application sur un substrat de la composition durcissable selon la revendication 21 afin de produire un substrat enduit, et
Le durcissement du substrat enduit afin de produire une composition durcie présentant un coefficient de dilatation thermique (CTE) ne dépassant pas les 60 ppm/°C.

23. Procédé de la revendication 22 comprenant le durcissement du substrat enduit pendant une période de temps allant de 20 à 60 minutes à une température allant de 100 à 240°C.

24. Procédé de production d'un ensemble de circuit intégré (100) comprenant
L'application sur un substrat de la composition durcissable produite selon le procédé de la revendication 1,
La pose d'une matrice en contact avec la composition appliquée, et
Le durcissement de la composition appliquée afin de produire un ensemble de circuit intégré (100),
Où au moins l'un des éléments substrat ou matrice comprend une ou plusieurs bosses (115).

25. Circuit intégré produit selon le procédé de la revendication 24 comprenant une composition durcie ayant un coefficient CTE de 35 à 50 ppm/°C.

26. Procédé de production d'un circuit intégré comprenant
La fourniture d'un substrat comprenant une ou plusieurs bosses d'appui (115) sur celui-ci,
L'application sur le substrat de la composition durcissable produite selon le procédé de la revendication 1,
La pose d'une matrice (110) sur la composition durcissable appliquée, la dite matrice (110) comprenant une ou plusieurs bosses pour puce retournée,
La soumission de l'ensemble (100) à une température suffisant à faire fondre et se joindre les bosses (115), et
La soumission de l'ensemble (100) à une température suffisant à provoquer le durcissement de la composition durcissable appliquée.

27. Procédé de la revendication 26 où les étapes de soumission de l'ensemble (100) à une température suffisant à provoquer le flux des bosses (115) et de soumission de l'ensemble (100) à une température suffisant à provoquer la réticulation de la composition durcissable appliquée sont des étapes exécutées simultanément.

28. Procédé de la revendication 26 où la plus grande partie de la réticulation de la composition durcissable se fait après l'étape de soumission de l'ensemble (100) à une température suffisant à provoquer le flux des bosses (115).
